# EUROPEAN PATENT SPECIFICATION

(11) **EP 2 463 095 B1**
(45) Date of publication and mention of the grant of the patent: **15.01.2020**
(21) Application number: 10806493.2
(22) Date of filing: 04.08.2010
(51) Int. Cl.: B32B 27/30, B32B 27/32, C03C 27/12

(54) **POLYVINYL ACETAL LAMINATE AND USE THEREOF**
POLYVINYL-ACETAL-LAMINAT UND VERWENDUNG DAVON
STRATIFIÉ DE POLY(ACÉTAL DE VINYLE) ET SON UTILISATION

(30) Priority: 07.08.2009 JP 2009185101; 07.08.2009 JP 2009185102
(43) Date of publication of application: 13.06.2012
(73) Proprietor: Kuraray Co., Ltd., Okayama 710-0801 (JP)
(72) Inventor: ASANUMA Yoshiaki, Kurashiki-shi Okayama 713-8550 (JP); TOKOH Makio, Tokyo 100-8115 (JP); ISOUE Koichiro, Kurashiki-shi Okayama 713-8550 (JP)
(74) Representative: Hoffmann Eitle
(86) International application number: PCT/JP2010/063206
(87) International publication number: WO 2011/016494

(56) References cited:
- EP-A1- 1 997 785
- EP-A1- 2 463 336
- WO-A1-2004/009354
- JP-A- 8 073 244
- JP-A- 64 001 737
- JP-A- 2002 046 217
- JP-A- 2004 050 750
- JP-A- 2007 091 491
- JP-A- 2007 254 207
- JP-A- 2008 208 003
- US-A- 5 364 479

## Description

### TECHNICAL FIELD

The present invention relates to a polyvinyl acetal laminate and use thereof.

### BACKGROUND ART

Polyvinyl acetal represented by polyvinyl butyral has excellent adhesiveness and compatibility with various organic and inorganic substrates and excellent solubility in an organic solvent. As such, it is widely used as various adhesives, and a binder for ceramics, various ink, paint, or the like, or an intermediate film of a safety glass.

Of the uses described above, for the purpose of obtaining high sound insulation property when used as an intermediate film of a laminated glass, studies are made regarding an intermediate film of a sound proof glass wherein a plasticized polyvinyl acetal sheet and a styrene-diene block copolymer sheet having an excellent sound insulation property are laminated (refer to Patent Documents 1 to 3) or a highly sound proof front board of a pachinko machine wherein such laminated glass is used (refer to Patent Document 4). However, according to a laminate of a plasticized polyvinyl acetal and a styrene-diene block copolymer, the adhesion between the plasticized polyvinyl acetal and the styrene-diene block copolymer is very poor and at their interface peeling is easily caused by moisture, external force, or a stress due to difference in heat expansion ratio between the plasticized polyvinyl acetal and the styrene-diene block copolymer. As a result, there have been problems like deterioration in function of a laminated glass or inferior appearance.

### CITATION LIST

### PATENT LITERATURE

Patent Document 1: Japanese Patent Application Laid-Open (JP-A) No. 2007-091491
Patent Document 2: JP-A No. 2005-306326
Patent Document 3: Japanese Patent National Application Publication (Laid-Open) No. 2001-506198
Patent Document 4: JP-A No. 2007-136057

### DISCLOSURE OF THE INVENTION

### PROBLEM TO BE SOLVED BY THE INVENTION

The present invention is devised to solve the problems described above and object of the invention is to provide a laminate of a layer that contains a polyvinyl acetal and a layer that contains a polyolefin (hydrocarbon polymer), which exhibits excellent adhesion between the layers, wherein it is used as an intermediate film of a laminated glass and for other applications.

### MEANS FOR SOLVING PROBLEM

Above mentioned object is accomplished by a laminate obtained by laminating a layer A that comprises a composition A containing a polyvinyl acetal and a layer B that comprises a composition B containing a polyolefin and an adhesive functional group-containing olefinic polymer, wherein a mass ratio of (the polyolefin) / (the adhesive functional group-containing olefinic polymer) is 0/100 to 99.95/0.05.

Above mentioned object is accomplished by a laminate obtained by laminating a layer A that comprises a composition A containing a polyvinyl acetal and a layer B that comprises a composition B containing a polyolefin and an adhesive functional group-containing olefinic polymer having an organometallic functional group that comprises boron and/or silicon (herein below, this is referred to as an "organometallic functional group-containing olefinic polymer"), wherein a mass ratio of (the polyolefin) / (the organometallic functional group-containing olefinic polymer) is 0/100 to 99.95/0.05, and the laminate obtained by laminating a the layer A and layer C that comprises a composition C containing a polyolefin via the layer B.

Above mentioned object is accomplished by a laminate obtained by laminating a layer A that comprises a composition A containing a polyvinyl acetal and a layer B that comprises a composition B containing a polyolefin and an adhesive functional group-containing olefinic polymer having at least one reactive functional group that is selected from a carboxyl group, a derivative group of a carboxyl group, and an epoxy group (herein below, this is referred to as a "reactive functional group-containing olefinic polymer"), wherein a mass ratio of (the polyolefin) / (the organometallic functional group-containing olefinic polymer) is 0/100 to 99.9/0.1, and the laminate obtained by laminating the layer A and a layer C that comprises a composition C containing a polyolefin via the layer B.

### EFFECT OF THE INVENTION

In the laminate of the invention, the composition B contains, as an essential component, an adhesive functional group-containing olefinic polymer. Preferred examples of the adhesive functional group-containing olefinic polymer include, although not specifically limited, an organometallic functional group-containing olefinic polymer or a functional group-containing olefinic polymer

When an organometallic functional group-containing olefinic polymer is used in the invention, silicon or boron contained in the organometallic functional group-containing olefinic polymer may react with the hydroxy group contained in the polyvinyl acetal to form a covalent bond, or may form a strong hydrogen bond with the hydroxy group contained in the polyvinyl acetal. Further, as the organometallic functional group-containing olefinic polymer mostly consists of a polymer of a hydrocarbon monomer, it can be adhered or used together with polyolefin which has relatively similar molecular polarity. Accordingly, a laminate which is obtained by laminating a layer A that comprises a composition A and a layer B that comprises a composition B or a laminate which is obtained by laminating a layer A and a layer C that comprises a composition C via a layer B that comprises a composition B has excellent interlayer adhesion between the layer A and the layer B or the layer A and layer C, and the laminates are particularly preferably used as an intermediate film of a laminated glass.

Further, when a reactive functional group-containing olefinic polymer is used in the invention, at least one group selected from a carboxyl group, a derivative of carboxyl group and an epoxy group in the reactive functional group-containing olefinic polymer may react with the hydroxy group contained in polyvinyl acetal to form a covalent bond. Further, since the reactive functional group-containing olefinic polymer mostly consists of a polymer of a polyolefinic monomer, it can be adhered or used together with polyolefin which has relatively similar molecular polarity. Accordingly, a laminate which is obtained by laminating a layer A that comprises a composition A and a layer B that comprises a composition B or a laminate which is obtained by laminating a layer A and a layer C that comprises a composition C via a layer B that comprises a composition B has excellent interlayer adhesion between the layer A and the layer B or the layer A and layer C, and the laminates are particularly preferably used as an intermediate film of a laminated glass.

### BRIEF DESCRIPTION OF THE DRAWINGS

FIG. 1 is a schematic drawing which illustrates an exemplary solar cell module in which the laminate of the invention and a crystal type solar cell are used.
FIG. 2 is a schematic drawing which illustrates an exemplary solar cell module in which the laminate of the invention and a thin film type solar cell are used.

### BEST MODES FOR CARRYING OUT THE INVENTION

First, the composition B used in the invention is explained herein below. The composition B used in the invention is not specifically limited if it comprises a polyolefin and an adhesive functional group-containing olefinic polymer wherein a mass ratio of (the polyolefin) / (the adhesive functional group-containing olefinic polymer) is 0/100 to 99.95/0.05. In the composition B of the invention, polyolefin is not an essential component. Specifically, (the polyolefin) / (the adhesive functional group-containing olefinic polymer) = 0/100 means that the composition B does not contain any polyolefin. Preferred examples of the adhesive functional group-containing olefinic polymer include, although not specifically limited, include an organometallic functional group-containing olefinic polymer and a reactive functional group-containing olefinic polymer.

When the adhesive functional group-containing olefinic polymer used in the composition B of the invention is an organometallic functional group-containing olefinic polymer, the polyolefin and the organometallic functional group-containing olefinic polymer are not specifically limited as long as a mass ratio of (the polyolefin) / (the organometallic functional group-containing olefinic polymer) is 0/100 to 99.95/0.05 in the composition B. It is more preferable that the mass ratio of (the polyolefin) / (the organometallic functional group-containing olefinic polymer) is 0/100 to 99.9/0.1. It is still more preferable that the mass ratio is 50/50 to 99.5/0.5. When the content of the organometallic functional group-containing olefinic polymer in the composition B is less than 0.05 in terms of mass compared to the total mass of the polyolefin and the organometallic functional group-containing olefinic polymer, the interlayer adhesion is deteriorated, and therefore undesirable.

The total mass of the polyolefin and the organometallic functional group-containing olefinic polymer contained in the composition B is not specifically limited as long as it is not against the main spirit of the invention. Compared to the mass of the composition B, it is preferably 30% by mass or more, more preferably 80% by mass or more, and most preferably 90% by mass or more. When the total content of the polyolefin and the organometallic functional group-containing olefinic polymer is less than 30% by mass compared to the mass of the composition B, the interlayer adhesion is deteriorated or low water absorption property or various dynamic properties inherent to the polyolefin or the organometallic functional group-containing olefinic polymer, and properties like sound proof property of a block copolymer described below tend to be lowered.

When the adhesive functional group-containing olefinic polymer used in the composition B of the invention is a reactive functional group-containing olefinic polymer, the polyolefin and the reactive functional group-containing olefinic polymer are not specifically limited as long as a mass ratio of (the polyolefin) / (the reactive functional group-containing olefinic polymer) is 0/100 to 99.95/0.05 in the composition B. It is more preferable that the mass ratio of (the polyolefin) / (the reactive functional group-containing olefinic polymer) is 0/100 to 99.9/0.1. It is still more preferable that the mass ratio is 50/50 to 99.5/0.5. When the content of the reactive functional group-containing olefinic polymer in the composition B is less than 0.05 in terms of mass compared to the total mass of the polyolefin and the reactive functional group-containing olefinic polymer, the interlayer adhesion is deteriorated, and therefore undesirable.

The total mass of the polyolefin and the reactive functional group-containing olefinic polymer contained in the composition B is not specifically limited as long as it is not against the main spirit of the invention. Compared to the mass of the composition B, it is preferably 30% by mass or more, more preferably 80% by mass or more, and most preferably 90% by mass or more. When the total content of the polyolefin and the reactive functional group-containing olefinic polymer is less than 30% by mass compared to the mass of the composition B, the interlayer adhesion is deteriorated or low water absorption property or various dynamic properties inherent to the polyolefin or the reactive functional group-containing olefinic polymer, and properties like sound proof property of a block copolymer described below tend to be lowered.

Next, the polyolefin used in the composition B or composition C of the invention is explained. The polyolefin used in the invention is not specifically limited, if it is a polymer which contains a hydrocarbon component as a main component, and it can be appropriately selected depending on specific purpose. However, a polymer of at least one compound selected from an aliphatic unsaturated hydrocarbon compound having 2 to 12 carbon atoms and an aromatic unsaturated hydrocarbon compound having 8 to 12 carbon atoms, or a hydrogenated molecule thereof are preferable in that they have excellent interlayer adhesion and various excellent dynamic properties and also they can be easily obtained. As used herein, a polymer of at least one compound selected from an aliphatic unsaturated hydrocarbon compound having 2 to 12 carbon atoms and an aromatic unsaturated hydrocarbon compound having 8 to 12 carbon atoms, or a hydrogenated molecule thereof are a polymer or a hydrogenated molecule thereof in which the total mass ratio of the aliphatic unsaturated hydrocarbon compound having 2 to 12 carbon atoms and aromatic unsaturated hydrocarbon compound having 8 to 12 carbon atoms is 80% by mass or more, preferably 95% by mass or more, and most preferably 98% by mass or more compared to whole monomers contained in the polymer. When the total mass ratio of the aliphatic unsaturated hydrocarbon compound having 2 to 12 carbon atoms and aromatic unsaturated hydrocarbon compound having 8 to 12 carbon atoms is less than 80% by mass compared to whole monomers contained in the polymer, the low water absorption property or various dynamic properties inherent to the polyolefin and properties like sound proof property of a block copolymer described below tend to be lowered.

Specific examples of the aliphatic unsaturated hydrocarbon compound having 2 to 12 carbon atoms include an aliphatic monoene compound like ethylene, propylene, butylene, 2-butylene, isobutylene, pentene, hexene, heptene, octane, nonene, decene, undecene, dodecane, cyclohexene, and cyclooctene, an aliphatic conjugated polyene compound like butadiene, isoprene, 1,3-hexadiene, 1,3-octadiene, 1,3,5-hexatriene, 1,3-cyclopentadiene, 1,3-cyclohexadiene, and 1,3-cyclooctadiene, and an aliphatic non-conjugated polyene compound like 1,4-pentadiene, 1,5-hexadiene, and 1,5-cyclooctadiene. Further, specific example of the aromatic unsaturated hydrocarbon compound having 8 to 12 carbon atoms include an aromatic monoene compound like styrene, α-methylstyrene, β-methylstyrene, 2-methylstyrene, 3-methylstyrene, 4-methylstyrene, 4-ethylstyrene, 4-butylstyrene, 4-tert-butylstyrene, (1-naphthyl)ethylene, and (2-naphthyl)ethylene, an aromatic conjugated polyene compound like 1-phenylbutadiene and 2-phenylbutadiene, and an aromatic non-conjugated polyene compound like 1-phenyl-1,4-pentadiene and 1-phenyl-1,3-cyclohexadiene, but not limited thereto.

From the viewpoint of being admixed with the adhesive functional group-containing olefinic polymer, the polyolefin used in the composition B contains only the compounds exemplified above as a monomer unit. On the other hand, the polyolefin used in the composition C may be copolymerized with, in addition to the compounds exemplified above, the following compounds within the range that the effect of the invention is not impaired: for example, acrylic acid and a salt thereof; acrylic esters like methyl acrylate, ethyl acrylate, n-propyl acrylate, i-propyl acrylate, n-butyl acrylate, i-butyl acrylate, t-butyl acrylate, 2-ethylhexylacrylate, dodecyl acrylate, and octadecyl acrylate; methacrylic acid and a salt thereof, methacrylate esters like methyl methacrylate, ethyl methacrylate, n-propyl methacrylate, i-propyl methacrylate, n-butyl methacrylate, i-butyl methacrylate, t-butyl methacrylate, 2-ethylhexyl methacrylate, dodecyl methacrylate, and octadecyl methacrylate; acrylamide and acrylamide derivative like N-methylacrylamide, N-ethylacrylamide, N,N-dimethylacrylamide, diacetone acrylamide, acrylamide propane sulfonic acid and a salt thereof, and N-methylol acrylamide and a derivative thereof; methacrylamide and methacrylamide derivative like N-methylmethacrylamide, N-ethylmethacrylamide, methacrylamide propane sulfonic acid and a salt thereof, and N-methylol methacrylamide or a derivative thereof; vinyl ethers like methyl vinyl ether, ethyl vinyl ether, n-propyl vinyl ether, i-propyl vinyl ether, n-butyl vinyl ether, i-butyl vinyl ether, t-butyl vinyl ether, dodecyl vinyl ether, and stearyl vinyl ether; nitriles like acrylonitrile and methacrylonitrile; vinyl halides like vinyl chloride and vinyl fluoride; vinylidene halide like vinylidene chloride and vinylidene fluoride; an allyl compound like allyl acetate and allyl chloride; maleic acid, a salt thereof, an ester thereof, or an anhydride thereof, and: isopropenyl acetate.

Specific examples of the polymer of at least one compound selected from an aliphatic unsaturated hydrocarbon compound having 2 to 12 carbon atoms and an aromatic unsaturated hydrocarbon compound having 8 to 12 carbon atoms, or a hydrogenated molecule include high density polyethylene, low density polyethylene, ultra low density polyethylene, polypropylene, polystyrene, polybutadiene, polyisoprene, an ethylene-propylene copolymer, hydrogenated polybutadiene, hydrogenated polyisoprene, and also a block copolymer like a styrene-butadiene block copolymer, a styrene-isoprene block copolymer, and a hydrogenated molecule thereof. Further, their polymerization method is not specifically limited, and a polymer obtained by a conventional polymerization method can be used, for example. When the laminate of the invention is used as an intermediate film of a sound proof laminated glass, a block copolymer of a block (X) consisting of a polymer of an aromatic unsaturated hydrocarbon compound having 8 to 12 carbon atoms and a block (Y) consisting of a polymer of an aliphatic conjugated polymer compound having 2 to 12 carbon atoms, and a hydrogenated molecule thereof (herein below, they are collectively referred to as a "block copolymer") like styrene-butadiene block copolymer, styrene-isoprene block copolymer, styrene-butadiene-isoprene copolymer, and a hydrogenated molecule thereof are preferably used as they have an excellent vibration damping property and sound proof property. Herein below, they are explained in greater detail.

The block copolymer used in the invention is not specifically limited if it has a block (X) part and a block (Y) part. For example, a block copolymer like[(X)-(Y)]ₖ and[(X)-(Y)]ₘ-(X), (Y)-[(X)-(Y)]ₙ can be used, wherein k, m, and n are any natural number. Among them, a block copolymer having two or more block (X) and one or more block (Y) is preferable. A triblock copolymer consisting of (X)-(Y)-(X) is particularly preferable. Further, when the block copolymer used in the invention contains two or more block (X) or two or more block (Y), each block (X) and block (Y) may be the same or different from each other.

Content of the block (X) and block (Y) in the block copolymer is not specifically limited if it is not against the purpose of the invention. However, from the viewpoint of vibration damping property and sound proof property, content of the block (X) is preferably 5 to 95% by mass, and more preferably 10 to 70% by mass compared to the total mass of the block copolymer. When the content of the block (X) is within the range, the vibration damping property and sound proof property inherent to the block copolymer are exhibited, and therefore desirable.

The weight average molecular weight of the block (X) and block (Y) in the block copolymer is not specifically limited. However, the weight average molecular weight per single block (X) is preferably 2,500 to 75,000, and the weight average molecular weight per single block (Y) is preferably 1,000 to 100,000. Further, the weight average molecular weight of the block copolymer is preferably 10,000 to 1,000,000, and more preferably 15,000 to 200,000. When the weight average molecular weight of the block (X) and block (Y) is too small, performance of the block copolymer may not be exhibited. Further, when the weight average molecular weight of the block copolymer is too small, dynamic strength may be lowered too much when it is prepared as a laminate. On the other hand, when the weight average molecular weight of the block copolymer is too big, handlability is impaired at the time of molding. Glass transition temperature, melting point or the like of the block copolymer may be appropriately selected depending on purpose.

Glass transition temperature of the block copolymer used in the invention is not specifically limited and it may be appropriately selected depending on purpose. However, it is preferably -50 to 50°C, more preferably -45 to 30°C, and still more preferably -40 to 20°C. When the glass transition temperature of the block copolymer satisfies the above condition, favorable dynamic physical properties and various favorable properties are obtained for the laminate of the invention.

The tanδ peak temperature of the block copolymer used in the invention is not specifically limited and it may be appropriately selected depending on purpose. However, it is preferably -40 to 30°C, more preferably -35 to 25°C, and still more preferably -30 to 20°C.

The dynamic strength of the block copolymer used in the invention is not specifically limited and it may be appropriately selected depending on purpose. However, when described as tensile break strength as an indicator, it is preferably 0.1 MPa or more, more preferably 0.5 MPa or more, and still more preferably 1.0 MPa or more.

The MFR value of the block copolymer used in the invention is not specifically limited and it may be appropriately selected depending on purpose. However, when measured according to ASTM D1238 with a load of 2.16 kg and temperature of 190°C, MRF value is preferably 0.1 to 100 g/10 min, more preferably 0.1 to 70 g/10 min, and still more preferably 0.1 to 50 g/ 10 min.

Block (Y) part of the block copolymer used in the invention may be either hydrogenated or non-hydrogenated. However, from the viewpoint of weatherability, it is preferably hydrogenated. The hydrogenation ratio is preferably 50 mol% or more, more preferably 80 mol% or more, and still more preferably 95 mol% or more.

The block copolymer described above may be produced by a conventionally known method. However, it may be also produced by a method in which an organolithium reagent is used as an initiator and an aromatic unsaturated hydrocarbon compound having 8 to 12 carbon atoms and an aliphatic conjugated polyene compound having 2 to 12 carbon atoms are added in order to react with each other, for example, but the production method is not limited thereto.

Next, the organometallic functional group-containing olefinic polymer used in the invention is explained. The organometallic functional group-containing olefinic polymer used in the invention is not specifically limited if it is an olefinic polymer containing a hydrocarbon component as a main component and at least one element selected from a boron and a silicon (herein below, referred to as an organometallic functional group). A polymer of at least one compound selected from an aliphatic unsaturated hydrocarbon compound having 2 to 12 carbon atoms and an aromatic unsaturated hydrocarbon compound having 8 to 12 carbon, which has an organometallic functional group at the terminal of a molecular chain or in a side chain, or a hydrogenated molecule thereof is preferable in that interlayer adhesion and various dynamic properties are excellent and the corresponding polymers can be easily obtained. Herein, the polymer of at least one compound selected from an aliphatic unsaturated hydrocarbon compound having 2 to 12 carbon atoms and an aromatic unsaturated hydrocarbon compound having 8 to 12 carbon, which has an organometallic functional group at the terminal of a molecular chain or in a side chain, or a hydrogenated molecule thereof means a polymer having an organometallic functional group at the terminal of a molecular chain or in a side chain, wherein the total content ratio of the aliphatic unsaturated hydrocarbon compound having 2 to 12 carbon atoms and aromatic unsaturated hydrocarbon compound having 8 to 12 carbon atoms compared to the whole monomers contained in the polymer is 30% by mass or more, preferably 80% by mass or more, and most preferably 90% by mass or more, or a hydrogenated molecule thereof. When the total content ratio of the aliphatic unsaturated hydrocarbon compound having 2 to 12 carbon atoms and aromatic unsaturated hydrocarbon compound having 8 to 12 carbon atoms compared to the whole monomers contained in the polymer is less than 30% by mass, the low water absorption property or various dynamic properties inherent to the organometallic functional group-containing olefinic polymer, and properties like sound proof property of a block copolymer described below tend to be lowered.

Specific examples of the aliphatic unsaturated hydrocarbon compound having 2 to 12 carbon atoms and aromatic unsaturated hydrocarbon compound having 8 to 12 carbon atoms include those exemplified above as a specific example of the aliphatic unsaturated hydrocarbon compound having 8 to 12 carbon atoms and aromatic unsaturated hydrocarbon compound having 8 to 12 carbon atoms for constituting the polyolefin. Further, the polymer of at least one compound selected from an aliphatic unsaturated hydrocarbon compound having 2 to 12 carbon atoms and an aromatic unsaturated hydrocarbon compound having 8 to 12 carbon, which has an organometallic functional group at the terminal of a molecular chain or in a side chain, or a hydrogenated molecule thereof means the polymer of at least one compound selected from an aliphatic unsaturated hydrocarbon compound having 2 to 12 carbon atoms and an aromatic unsaturated hydrocarbon compound having 8 to 12 carbon that are the same as those exemplified above, which has an organometallic functional group at the terminal of a molecular chain or in a side chain, or a hydrogenated molecule thereof.

When the laminate of the invention is particularly used as an intermediate film of a sound proof laminated glass, a block copolymer of a block (X') consisting of a polymer of an aromatic unsaturated hydrocarbon compound having 8 to 12 carbon atoms and a block (Y') consisting of a polymer of an aliphatic conjugated polymer compound having 2 to 12 carbon atoms, and a hydrogenated molecule thereof like styrene-butadiene block copolymer, styrene-isoprene block copolymer, styrene-butadiene-isoprene copolymer, and a hydrogenated molecule thereof, which has an organometallic functional group at the terminal of a molecular chain or in a side chain, or a hydrogenated molecule thereof (herein below, they are collectively referred to as an "organometallic functional group-containing block copolymer") are preferably used as they have an excellent vibration damping property and sound proof property, and also show excellent compatibility and adhesion when the block copolymer is used as a polyolefin of the laminate of the invention. Herein, the block (X') and/or block (Y') may contain an organometallic functional group-containing part in the block.

The organometallic functional group-containing block copolymer used in the invention is not specifically limited if it has a block (X') part and a block (Y') part. For example, a block copolymer like [(X')-(Y')]_{k'} and [(X')-(Y')]_{m'}-(X'), (Y')-[(X')-(Y')]_{n'} can be used, wherein k', m', and n' are any natural number. Among them, a block copolymer having two or more block (X') and one or more block (Y') is preferable. A triblock copolymer consisting of (X')-(Y')-(X') is particularly preferable. Further, when the organometallic functional group-containing block copolymer used in the invention contains two or more block (X') or two or more block (Y'), each block (X') and block (Y') may be the same or different from each other.

Content of the block (X') and block (Y') in the organometallic functional group-containing block copolymer is not specifically limited if it is not against the purpose of the invention. However, content of the block (X') is preferably 5 to 95% by mass, and more preferably 10 to 70% by mass compared to the total mass of the organometallic functional group-containing block copolymer. When the content of the block (X') is within the range, the vibration damping property and sound proof property inherent to the block copolymer are exhibited.

The number average molecular weight of the block (X') and block (Y') in the organometallic functional group-containing block copolymer is not specifically limited. However, the number average molecular weight per single block (X') is preferably 2,500 to 75,000, and the number average molecular weight per single block (Y') is preferably 1,000 to 100,000. Further, the number average molecular weight of the organometallic functional group-containing block copolymer is preferably 10,000 to 1,000,000, and more preferably 15,000 to 200,000. When the weight average molecular weight of the block (X') and block (Y') is too small, performance of the block copolymer may not be exhibited. Further, when the weight average molecular weight of the organometallic functional group-containing block copolymer is too small, dynamic strength may be lowered too much when it is prepared as a laminate. On the other hand, when the weight average molecular weight of the organometallic functional group-containing block copolymer is too big, handlability is impaired at the time of molding. Glass transition temperature, melting point or the like of the organometallic functional group-containing block copolymer may be appropriately selected depending on purpose.

Glass transition temperature of the organometallic functional group-containing block copolymer used in the invention is not specifically limited and it may be appropriately selected depending on purpose. However, it is preferably -100 to 50°C, more preferably -50 to 30°C, and still more preferably -40 to 20°C. When the glass transition temperature of the organometallic functional group-containing block copolymer satisfies the above condition, favorable dynamic physical properties and various favorable properties are obtained for the laminate of the invention.

The tanδ peak temperature of the organometallic functional group-containing block copolymer used in the invention is not specifically limited and it may be appropriately selected depending on purpose. However, it is preferably -40 to 30°C, more preferably -35 to 25°C, and still more preferably -30 to 20°C.

The dynamic strength of the organometallic functional group-containing block copolymer used in the invention is not specifically limited and it may be appropriately selected depending on purpose. However, when described as tensile break strength as an indicator, it is preferably 0.1 MPa or more, more preferably 0.5 MPa or more, and still more preferably 1.0 MPa or more.

The MFR value of the organometallic functional group-containing block copolymer used in the invention is not specifically limited and it may be appropriately selected depending on purpose. However, when measured according to ASTM D1238 with a load of 2.16 kg and temperature of 190°C, MRF value is preferably 0.1 to 100 g/10 min, more preferably 0.1 to 70 g/10 min, and still more preferably 0.1 to 50 g/10 min.

Block (Y') part of the organometallic functional group-containing block copolymer used in the invention may be either hydrogenated or non-hydrogenated. However, from the viewpoint of weatherability, it is preferably hydrogenated. The hydrogenation ratio is preferably 50 mol% or more, more preferably 80 mol% or more, and still more preferably 90 mol% or more.

The organometallic functional group contained in the organometallic functional group-containing olefinic polymer used in the invention is not specifically limited. However, preferred examples of the polymer include an olefinic polymer wherein the organometallic functional group is at least one group selected from a boronic acid group, a boronic acid derivative group, a borinic acid, and a borinic acid derivative group (a boron functional group) (i.e., a boron functional group-containing olefinic polymer) or an olefinic polymer having at least one of an alkoxysilyl group and an alkoxysilyl derivative group (a silicon functional group) (i.e., a silicon functional group-containing olefinic polymer), as favorable interlayer adhesion can be obtained therewith. Specifically, the boron functional group-containing olefinic polymer is preferable in that it has excellent handlability as it causes no or almost no polymerization by itself and the silicon functional group-containing olefinic polymer is preferable in that raw materials thereof can be relatively easily obtained. Herein below, they are explained in order.

First, the boron functional group-containing olefinic polymer is explained. The boron functional group-containing olefinic polymer used in the invention is not specifically limited if it is an olefinic polymer containing at least one group (a boron functional group) selected from a boronic acid group, a boronic acid derivative group, a borinic acid, and a borinic acid derivative group. As used herein, the boronic acid group indicates a group having a structure represented by the formula (1):

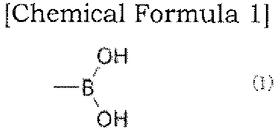

Further, the boronic acid derivative group means a functional group capable of converting into a boronic acid group by hydrolysis and it specifically indicates a boronic acid ester group represented by the formula (2): 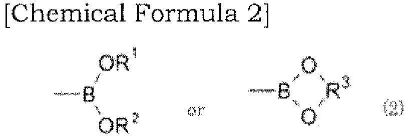 (wherein, R¹ and R² represent a group selected from a hydrogen atom and a monovalent organic group having 1 to 20 carbon atoms (e.g., an aliphatic hydrocarbon group (a linear or branched alkyl group or alkenyl group or the like), an alicyclic hydrocarbon group (a cycloalkyl group, a cycloalkenyl group or the like), and an aromatic hydrocarbon group (a phenyl group, a biphenyl group, or the like)), R¹ and R² may be the same or different from each other, at least one of R¹ and R² is not a hydrogen atom, and R³ is a divalent organic group having 1 to 30 carbon atoms), a boronic anhydride group represented by the formula (3): 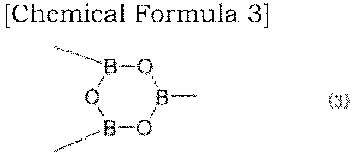 and a boronic acid salt group represented by the formula (4): 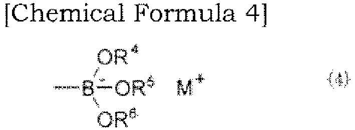 (wherein, R⁴, R⁵ and R⁶ represent a group selected from a hydrogen atom and a monovalent organic group having 1 to 20 carbon atoms (e.g., an aliphatic hydrocarbon group (a linear or branched alkyl group or alkenyl group or the like), an alicyclic hydrocarbon group (a cycloalkyl group, a cycloalkenyl group or the like), and an aromatic hydrocarbon group (a phenyl group, a biphenyl group, or the like)), R⁴, R⁵ and R⁶ may be the same or different from each other, and M⁺ is a monovalent cation). Further, the borinic acid in the invention indicates a group having the structure represented by the formula (5) except the boronic acid group:

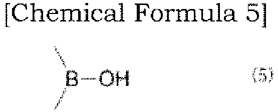

The borinic acid derivative group means a functional group capable of converting into a borinic acid group by hydrolysis and it specifically indicates a borinic acid ester group represented by the formula (6): 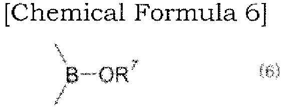 (wherein, R⁷ represents a monovalent organic group having 1 to 20 carbon atoms (e.g., an aliphatic hydrocarbon group (a linear or branched alkyl group or alkenyl group or the like), an alicyclic hydrocarbon group (a cycloalkyl group, a cycloalkenyl group or the like), and an aromatic hydrocarbon group (a phenyl group, a biphenyl group, or the like)), a borinic anhydride group represented by the formula (7): 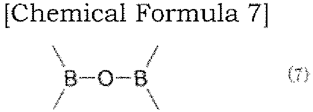 and the borinic acid salt group represented by the formula (8): 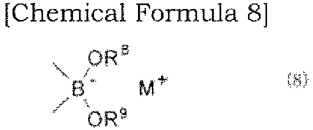 (wherein, R⁸ and R⁹ represent a group selected from a hydrogen atom and a monovalent organic group having 1 to 20 carbon atoms (e.g., an aliphatic hydrocarbon group (a linear or branched alkyl group or alkenyl group or the like), an alicyclic hydrocarbon group (a cycloalkyl group, a cycloalkenyl group or the like), and an aromatic hydrocarbon group (a phenyl group, a biphenyl group, or the like)), R⁸ and R⁹ may be the same or different from each other, and M⁺ is a monovalent cation). Specific examples of the boronic acid derivative represented by the formula (2), (3), or (4) include a boronic acid ester group like a boronic acid dimethyl ester group, a boronic acid diethyl ester group, a boronic acid dipropyl ester group, a boronic acid diisopropyl ester group, a boronic acid dibutyl ester group, a boronic acid dihexyl ester group, a boronic acid dicyclohexyl group, a boronic acid ethylene glycol ester group, a boronic acid propylene glycol ester group (boronic acid 1,2-propane diol ester group, a boronic acid 1,3-propane diol ester group), boronic acid (1,3-butane diol) ester group, a boronic acid trimethylene glycol ester group, a boronic acid neopentyl glycol ester group, a boronic acid catechol ester group, a boronic acid glycerin ester group, and a boronic acid trimethylol ethane ester group; a boronic acid anhydride group, an alkali metal salt of boronic acid, and an alkali earth metal salt of boronic acid. Specific examples of the borinic acid derivative represented by the formula (6), (7), or (8) include a methyl borinic acid group, a methyl borinic acid methyl ester group, an ethyl borinic acid methyl ester group, a methyl borinic acid ethyl ester group, a butyl borinic acid methyl ester group, and a 3-methyl-2-butyl borinic acid methyl ester group. Of these, the boronic acid group, boronic acid (1,3-butane diol) ester group, and boronic acid (propylene glycol) ester group are preferable from the viewpoint of interlayer adhesion of a laminate to be obtained.

Specific examples of the monovalent hydrocarbon group having 1 to 20 carbon atoms as R¹, R², R⁴ to R⁹ in the formula (2), the formula (4), the formula (6) and the formula (8) include a methyl group, an ethyl group, a propyl group, an isopropyl group, a butyl group, a 2-butyl group, a tert-butyl group, a pentyl group, a hexyl group, a heptyl group, an octyl group, a nonyl group, a decyl group, a dodecyl group, a hexadecyl group, a cyclohexyl group, a phenyl group, a 2-methylphenyl group, a 3-methylphenyl group, a 4-methylphenyl group, a 4-ethylphenyl group, a 2-naphthyl group, a 3-naphthyl group, a benzyl group, a 2-methoxyethyl group, a 2-ethoxyethyl group, a 2-butoxyethyl group, a 2-ethoxybutyl group, a 4-ethoxybutyl group, a chloromethyl group, a 1-chloroethyl group, a 2-chloroethyl group, and an acetyl group, but not limited thereto. Further, specific examples of R³ in the formula (2) include a 1,2-ethylene group, a 1,2-propylene group, a 1,3-propylene group, a 1,2-butylene group, a 2,3-butylene group, a 1,3-butylene group, a 2,3-dimethyl-2,3-butylene group (the boronic acid ester having this group as R³ is generally referred to as boronic acid pinacol ester), 2,2-dimethyl-1,3-propylene, N-phenyl-3-aza-1,5-pentyl group, a 1,2-phenylene group (the boronic acid ester having this group as R³ is generally referred to as boronic acid catechol ester), a 4,5-dimethyl-1,2-phenylene group, but not limited thereto. Further, specific examples of M⁺ in the formula (4) and (8) include a lithium ion, a sodium ion, a potassium ion, an ammonium ion, a triethylammonium ion, and a pyridinium ion, but not limited thereto.

The boron functional group-containing olefinic polymer used in the invention may be produced according to a conventionally known method and used. For example, it is obtained by reacting an olefinic polymer having carbon-carbon double bond with boranes, a borane complex, or a boronic acid ester compound having a boron-hydrogen bond, if necessary, in the presence of a boric acid alkyl ester, and also reacting with water or alcohols, if necessary. In this case, when the carbon-carbon double bond is present in the main chain or in the side chain, the boron functional group is introduced at the side chain. If it is present at the terminal, the boron functional group is introduced at the terminal.

The boranes, borane complex, or compound having a boron-hydrogen bond that is used for the reaction are not specifically limited. However, examples thereof include boranes like diborane, tetraborane, pentaborane, hexaborane, and decaborane, a borane complex like borane-tetrahydrofuran complex, borane-triethylamine complex, borane-trimethylamine complex, borane-pyridine complex, borane-t-butylamine complex, borane-N,N-diisopropylethylamine complex, borane-dimethylamine complex, borane-N,N-diethylaniline complex, borane-4-methylmorpholine complex, borane-methylsulfide complex, borane-1,4-thioxane complex, and borane-tributylphosphine complex, and a compound having a boron-hydrogen bond like texyl borane, catechol borane, 9-borabicyclo[3,3,1]nonane, diisoamyl borane, and dicyclohexyl borane. Of these, from the viewpoint of chemical stability, borane triethylamine complex, borane-methylsulfide complex or the like are preferable. Further, the amount of the compound used for the reaction is, although not specifically limited, about 0.1 to 10 equivalents compared to the amount of the carbon-carbon double bond.

Further, when boric acid alkyl ester is used, trimethyl borate, triethyl borate, tripropyl borate, tributyl borate, boric acid ethylene glycol ester, boric acid propylene glycol ester, boric acid trimethylene glycol ester, boric acid 1,3-butane diol ester, and boric acid neopentyl glycol ester are preferably used. Of these, esters like boric acid trimethylene glycol ester, boric acid propylene glycol ester, boric acid 1,3-butane diol ester, and boric acid neopentyl glycol ester are preferable. By adding a boric acid alkyl ester, crosslinking which often occurs at the time of adding the boranes, a borane complex, or a compound having a boron-hydrogen bond can be prevented and also a boron-containing group can be introduced in chemically stable form of boronic acid ester group. Further, examples of the alcohols used for the reaction include methanol, ethanol, propylene glycol, trimethylene glycol, and 1,3-butane diol.

The reaction between the carbon-carbon double bond-containing olefinic polymer and the borane complex and boric acid alkyl ester is carried out preferably at the temperature of room temperature to 400°C, and more preferably 100 to 350°C, for 1 min to 10 hours, and preferably 5 min to 5 hours. Further, the reaction can be also carried out by using an optional organic solvent.

Specific examples of the carbon-carbon double bond-containing olefinic polymer used in the invention include high density polyethylene, low density polyethylene, polypropylene, polystyrene, polybutadiene, polyisoprene, an ethylene-propylene copolymer, hydrogenated polybutadiene, hydrogenated polyisoprene and also a block copolymer having a carbon-carbon double bond like styrene-butadiene block copolymer, styrene-isoprene block copolymer, and styrene-butadiene-isoprene copolymer. It can be prepared according to a method conventionally known in the art, and for example it can be produced by a method including thermolysis of an olefinic polymer having no carbon-carbon double bond preferably at the temperature of 200°C or above to give an olefinic polymer having a carbon-carbon double bond at the terminal. Further, a conjugated polyene compound like polybutadiene and styrene-butadiene block copolymer in which hydrogenation ratio is not 100% can be also used as a carbon-carbon double bond-containing olefinic polymer. In particular, the latter is easily obtainable in a state in which plural carbon-carbon double bonds are contained in a main chain or a side chain. Thus, it is more suitable for obtaining a boron functional group-containing olefinic polymer in which the boron functional group is contained in a great amount.

The boron functional group contained in the boron functional group-containing olefinic polymer produced according to the method described above can be converted to other group by a conventionally known method. For example, the boronic acid ester group can be converted to a boronic acid group by a conventionally known hydrolysis method. Further, according to a reaction with any alcohol, an ester exchange reaction can be achieved. Still further, according to dehydration condensation between boronic acid groups, it can be converted to boronic anhydride group.

As another method for synthesizing a boron functional group-containing olefinic polymer, there is a method of radical polymerizing an unsaturated hydrocarbon in the presence of a compound having a mercapto group and a boron functional group. According to this method, a compound having a mercapto group and a boron functional group functions as a chain transfer agent for polymerization of an unsaturated hydrocarbon so that a boron functional group-containing olefinic polymer having a terminal boron functional group is obtained. Examples of the compound having a mercapto group and a boron functional group that can be used include 3-mercaptopropyl boronic acid pinacol ester and 4-mercaptophenyl boronic acid pinacol ester, but not limited thereto. The polymerization condition is not specifically limited, either. As long as it is not against the main spirit of the invention, it can be polymerized by a conventionally known method (e.g., a polyolefin polymerization in which a mercapto compound is used as a chain transfer agent).

As yet another method, there is a method of copolymerizing an unsaturated hydrocarbon compound with a compound copolymerizable with an unsaturated hydrocarbon compound as a compound having a carbon-carbon double bond and a boron functional group. According to this method, a boron functional group-containing olefinic polymer having a boron functional group in a main chain and/or side chain is obtained. Examples of the compound having a carbon-carbon double bond and a boron functional group include vinylboronic acid pinacol ester, vinylboronic acid catechol ester, and allylboronic acid pinacol ester, but not limited thereto. The polymerization method is not specifically limited, either. As long as it is not against the main spirit of the invention, it can be polymerized by a conventionally known method.

Next, the silicon functional group-containing olefinic polymer is explained herein below. The silicon functional group-containing olefinic polymer used in the invention is not specifically limited, if it is an olefinic polymer containing at least one group selected from an alkoxysilyl group and a derivative group thereof (i.e., a silicon functional group). Herein, the alkoxysilyl group indicates a group having a structure represented by the formula (9): 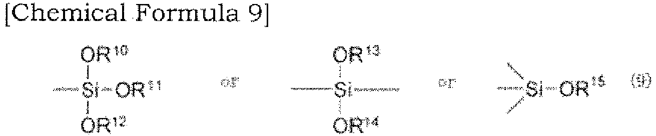 (wherein, R¹⁰, R¹¹, R¹², R¹³, R¹⁴ and R¹⁵ represent a monovalent organic group having 1 to 20 carbon atoms (e.g., an aliphatic hydrocarbon group (a linear or branched alkyl group or alkenyl group or the like), an alicyclic hydrocarbon group (a cycloalkyl group, a cycloalkenyl group or the like), and an aromatic hydrocarbon group (a phenyl group, a biphenyl group, or the like), R¹⁰, R¹¹ and R¹² may be the same or different from each other, and R¹³ and R¹⁴ may be the same or different from each other). Further, the derivative group of an alkoxysilyl group represents a silanol group represented by the formula (10): 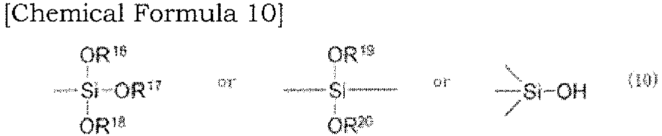 (wherein, R¹⁶, R¹⁷, R¹⁸, R¹⁹ and R²⁰ represent a group selected from a hydrogen atom and a monovalent organic group having 1 to 20 carbon atoms (e.g., an aliphatic hydrocarbon group (a linear or branched alkyl group or alkenyl group or the like), an alicyclic hydrocarbon group (a cycloalkyl group, a cycloalkenyl group or the like), and an aromatic hydrocarbon group (a phenyl group, a biphenyl group, or the like)), at least one of R¹⁶, R¹⁷, and R¹⁸ is a hydrogen atom, R¹⁶, R¹⁷, and R¹⁸ are the same or different from each other, at least one of R¹⁹ and R²⁰ is a hydrogen atom, and R¹⁹ and R²⁰ are the same or different from each other), or an silic anhydride group represented by the formula (11): 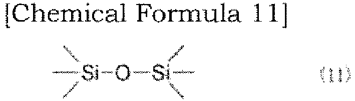 which contains a Si-O-Si bond produced by dehydration condensation between Si-OH in a silanol group and Si-OH in other silanol group. Of these, the alkoxysilyl group is preferable from the viewpoint of interlayer adhesion of a laminate to be obtained.

Specific examples of the monovalent organic group as R¹⁰ to R¹⁵ and R¹⁶ to R²⁰ include a methyl group, an ethyl group, a propyl group, an isopropyl group, a butyl group, a 2-butyl group, a tert-butyl group, a pentyl group, a hexyl group, a heptyl group, an octyl group, a nonyl group, a decyl group, a dodecyl group, a hexadecyl group, a cyclohexyl group, a phenyl group, a 2-methylphenyl group, a 3-methylphenyl group, a 4-methylphenyl group, a 4-ethylphenyl group, a 2-naphthyl group, a 3-naphthyl group, a benzyl group, a 2-methoxyethyl group, a 2-ethoxyethyl group, a 2-butoxyethyl group, a 2-ethoxybutyl group, a 4-ethoxybutyl group, a chloromethyl group, a 1-chloroethyl group, a 2-chloroethyl group, and an acetyl group, but not limited thereto.

The silicon functional group-containing olefinic polymer used in the invention can be produced according to a conventionally known method and used. For example, when styrene, butadiene, isoprene, or the like are polymerized (or copolymerized) in the presence of an organolithium compound, and then reacted with a compound having an alkoxysilyl group like methyl trimethoxysilane and methyl triphenoxysilane, an olefinic polymer having a silicon functional group at the terminal of a molecular chain can be obtained.

The silicon functional group-containing olefinic polymer can be produced by reacting a carbon-carbon double bond-containing olefinic polymer with a compound having a Si-H residue and a silicon functional group, preferably a compound in which a hydrogen atom is directly bonded to a silicon functional group, or a compound having a mercapto group and a silicon functional group. When the carbon-carbon double bond is present in the main chain or in the side chain, the silicon functional group is introduced at the side chain. If it is present at the terminal, the silicon functional group is introduced at the terminal.

The compound having a Si-H residue and a silicon functional group is not specifically limited, and examples thereof include trimethoxysilane, triethoxysilane, diethoxysilane, and methyl diethoxysilane. Examples of the compound having a mercapto group and a silicon functional group include, although not specifically limited, 2-mercaptoethyltrimethoxysilane, 3-mercaptopropyltrimethoxysilane, and 3-mercaptopropyltriethoxysilane. Further, the amount of the compound having a Si-H residue and a silicon functional group or the amount of the compound having a mercapto group and a silicon functional group is, although not specifically limited, about 0.1 to 10 equivalents compared to the amount of the carbon-carbon double bond.

Specific examples of the carbon-carbon double bond-containing olefinic polymer used for the reaction include those exemplified for the carbon-carbon double bond-containing olefinic polymer which is used for the reaction between a borane complex and boric acid alkyl ester as described above, but not limited thereto. Further, since the polymer of a conjugated polyene compound in which hydrogenation ratio is not 100% is easily obtainable in a state in which plural carbon-carbon double bonds are contained in a main chain or a side chain, it is more suitable for obtaining a silicon functional group-containing olefinic polymer in which the silicon functional group is contained in a great amount.

The reaction between the carbon-carbon double bond-containing olefinic polymer and a compound having a Si-H residue and a silicon functional group is carried out preferably at the temperature of room temperature to 300°C, and more preferably 100 to 250°C, for 1 min to 10 hours, and preferably 5 min to 5 hours. Further, the reaction can be also carried out by using an optional organic solvent.

As another method for synthesizing a silicon functional group-containing olefinic polymer, there is a method of radical polymerizing an unsaturated hydrocarbon in the presence of a compound having a mercapto group and a silicon functional group. According to this method, a compound having a mercapto group and a silicon functional group functions as a chain transfer agent for polymerization of an unsaturated hydrocarbon so that a silicon functional group-containing olefinic polymer having a terminal silicon functional group is obtained. Examples of the compound having a mercapto group and a silicon functional group that can be used include 3-mercaptopropyl trimethoxysilane, 3-mercaptopropyl triethoxysilane, and 4-mercaptophenyl trimethoxysilane, but not limited thereto. The polymerization method is not specifically limited, either. As long as it is not against the main spirit of the invention, it can be polymerized by a conventionally known method.

As yet another method, there is a method of copolymerizing an unsaturated hydrocarbon compound with a compound copolymerizable with an unsaturated hydrocarbon compound as a compound having a carbon-carbon double bond and a silicon functional group. According to this method, a silicon functional group-containing olefinic polymer having a silicon functional group in a main chain and/or side chain is obtained. Examples of the compound having a carbon-carbon double bond and a silicon functional group include vinyl trimethoxysilane, vinyl triethoxysilane, allyl trimethoxirane, and 3-(meth)acryloxypropyl trimethoxysilane, but not limited thereto. The polymerization method is not specifically limited, either. As long as it is not against the main spirit of the invention, it can be polymerized by a conventionally known method

Next, the reactive functional group-containing olefinic polymer used in the invention is explained. The reactive functional group-containing olefinic polymer used in the invention is not specifically limited if it is an olefinic polymer containing a hydrocarbon component as a main component and at least one group selected from a carboxyl group, a derivative group of carboxyl group, and an epoxy group (herein below, referred to as a reactive functional group). A polymer of at least one compound selected from an aliphatic unsaturated hydrocarbon compound having 2 to 12 carbon atoms and an aromatic unsaturated hydrocarbon compound having 8 to 12 carbon, which has a reactive functional group at the terminal of a molecular chain or in a side chain, or a hydrogenated molecule thereof is preferable in that interlayer adhesion and various dynamic properties are excellent and the corresponding polymers can be easily obtained. Herein, the polymer of at least one compound selected from an aliphatic unsaturated hydrocarbon compound having 2 to 12 carbon atoms and an aromatic unsaturated hydrocarbon compound having 8 to 12 carbon, which has a reactive functional group at the terminal of a molecular chain or in a side chain, or a hydrogenated molecule thereof means a polymer having a reactive functional group at the terminal of a molecular chain or in a side chain, wherein the total content ratio of the aliphatic unsaturated hydrocarbon compound having 2 to 12 carbon atoms and aromatic unsaturated hydrocarbon compound having 8 to 12 carbon atoms compared to the whole monomers contained in the polymer is 80% by mass or more, preferably 95% by mass or more, and most preferably 98% by mass or more, or a hydrogenated molecule thereof. When the total content ratio of the aliphatic unsaturated hydrocarbon compound having 2 to 12 carbon atoms and aromatic unsaturated hydrocarbon compound having 8 to 12 carbon atoms compared to the whole monomers contained in the polymer is less than 80% by mass, the low water absorption property or various dynamic properties inherent to the reactive functional group-containing olefinic polymer, and properties like sound proof property of a block copolymer described below tend to be lowered.

The carboxyl group and a derivative group of carboxyl group indicate a carboxyl group, a carboxylate group, a carboxylic acid ester group, and a carboxylic anhydride group, respectively. Herein, the carboxylate group indicates a carboxyl group of which hydrogen is substituted with a cation (M), i.e., a -COOM group. Examples of the M include a cation like lithium, sodium, potassium, magnesium, calcium, zinc, ammonium, triethylammonium, and pyridinium. Further, the carboxylic acid ester group indicates a carboxyl group of which hydrogen is substituted with an organic group having 1 to 20 carbon atoms. Specific examples of the organic group having 1 to 20 carbon atoms include a methyl group, an ethyl group, a propyl group, an isopropyl group, a butyl group, a 2-butyl group, a tert-butyl group, a pentyl group, a hexyl group, a heptyl group, an octyl group, a nonyl group, a decyl group, a dodecyl group, a hexadecyl group, a cyclohexyl group, a phenyl group, a 2-methylphenyl group, a 3-methylphenyl group, a 4-methylphenyl group, a 4-ethylphenyl group, a 2-naphthyl group, a 3-naphthyl group, a benzyl group, a 2-methoxyethyl group, a 2-ethoxyethyl group, a 2-butoxyethyl group, a 2-ethoxybutyl group, and a 4-ethoxybutyl group.

Specific examples of the aliphatic unsaturated hydrocarbon compound having 2 to 12 carbon atoms and aromatic unsaturated hydrocarbon compound having 8 to 12 carbon atoms include those exemplified above as a specific example of the aliphatic unsaturated hydrocarbon compound having 8 to 12 carbon atoms and aromatic unsaturated hydrocarbon compound having 8 to 12 carbon atoms for constituting the polyolefin. Further, the polymer of at least one compound selected from an aliphatic unsaturated hydrocarbon compound having 2 to 12 carbon atoms and an aromatic unsaturated hydrocarbon compound having 8 to 12 carbon, which has a reactive functional group at the terminal of a molecular chain or in a side chain, or a hydrogenated molecule thereof means the polymer of at least one compound selected from an aliphatic unsaturated hydrocarbon compound having 2 to 12 carbon atoms and an aromatic unsaturated hydrocarbon compound having 8 to 12 carbon as exemplified above, which has a reactive functional group at the terminal of a molecular chain or in a side chain, or a hydrogenated molecule thereof.

When the laminate of the invention is particularly used as an intermediate film of a sound proof laminated glass, a block copolymer of a block (X") consisting of a polymer of an aromatic unsaturated hydrocarbon compound having 8 to 12 carbon atoms and a block (Y") consisting of a polymer of an aliphatic conjugated polymer compound having 2 to 12 carbon atoms, and a hydrogenated molecule thereof like styrene-butadiene block copolymer, styrene-isoprene block copolymer, styrene-butadiene-isoprene copolymer, and a hydrogenated molecule thereof, which has reactive functional group at the terminal of a molecular chain or in a side chain, or a hydrogenated molecule thereof (herein below, they are collectively referred to as a "reactive functional group-containing block copolymer") are preferably used as they have an excellent vibration damping property and sound proof property, and also show excellent compatibility and adhesion when the block copolymer is used as a polyolefin of the laminate of the invention. Herein, the block (X") and/or block (Y") may contain reactive functional group-containing part in the block.

The reactive functional group-containing block copolymer used in the invention is not specifically limited if it has a block (X") part and a block (Y") part. For example, a block copolymer like [(X")-(Y")]_{k'} and [(X")-(Y")]_{m'}-(X"), (Y")-[(X")-(Y")]_{n'} can be used, wherein k', m', and n' are any natural number. Among them, a block copolymer having two or more block (X") and one or more block (Y") is preferable. A triblock copolymer consisting of (X")-(Y")-(X") is particularly preferable. Further, when reactive functional group-containing block copolymer used in the invention contains two or more block (X") or two or more block (Y"), each block (X") and block (Y") may be the same or different from each other.

Content of the block (X") and block (Y") in the reactive functional group-containing block copolymer is not specifically limited if it is not against the purpose of the invention. However, content of the block (X") is preferably 5 to 95% by mass, and more preferably 10 to 70% by mass compared to the total mass of the reactive functional group-containing block copolymer. When the content of the block (X") is within the range, the vibration damping property and sound proof property inherent to the block copolymer are exhibited.

The number average molecular weight of the block (X") and block (Y") in the reactive functional group-containing block copolymer is not specifically limited. However, the number average molecular weight per single block (X") is preferably 2,500 to 75,000, and the number average molecular weight per single block (Y") is preferably 1,000 to 100,000. Further, the number average molecular weight of the reactive functional group-containing block copolymer is preferably 10,000 to 1,000,000, and more preferably 15,000 to 200,000. When the weight average molecular weight of the block (X") and block (Y") is too small, performance of the block copolymer may not be exhibited. Further, when the weight average molecular weight of the reactive functional group-containing block copolymer is too small, dynamic strength may be lowered too much when it is prepared as a laminate. On the other hand, when the weght average molecular weight of the reactive functional group-containing block copolymer is too big, handlability is impaired at the time of molding. Glass transition temperature, melting point or the like of the reactive functional group-containing block copolymer may be appropriately selected depending on purpose.

Glass transition temperature of the reactive functional group-containing block copolymer used in the invention is not specifically limited and it may be appropriately selected depending on purpose. However, it is preferably -100 to 50°C, more preferably -50 to 30°C, and still more preferably -40 to 20°C. When the glass transition temperature of the reactive functional group-containing block copolymer satisfies the above condition, favorable dynamic physical properties and various favorable properties are obtained for the laminate of the invention.

The tanδ peak temperature of the reactive functional group-containing block copolymer used in the invention is not specifically limited and it may be appropriately selected depending on purpose. However, it is preferably -40 to 30°C, more preferably -35 to 25°C, and still more preferably -30 to 20°C.

The dynamic strength of the reactive functional group-containing block copolymer used in the invention is not specifically limited and it may be appropriately selected depending on purpose. However, when described as tensile break strength as an indicator, it is preferably 0.1 MPa or more, more preferably 0.5 MPa or more, and still more preferably 1.0 MPa or more.

The MFR value of the reactive functional group-containing block copolymer used in the invention is not specifically limited and it may be appropriately selected depending on purpose. However, when measured according to ASTM D1238 with a load of 2.16 kg and temperature of 190°C, MRF value is preferably 0.1 to 100 g/ 10 min, more preferably 0.1 to 70 g/10 min, and still more preferably 0.1 to 50 g/ 10 min.

Block (Y") part of the reactive functional group-containing block copolymer used in the invention may be either hydrogenated or non-hydrogenated. However, from the viewpoint of weatherability, it is preferably hydrogenated. The hydrogenation ratio is preferably 50 mol% or more, more preferably 80 mol% or more, and still more preferably 90 mol% or more.

As for the reactive functional group-containing olefinic polymer used in the invention, an olefinic polymer wherein the functional group is at least one group selected from a carboxyl group and a derivative group of a carboxyl group (herein below, referred to as carboxylic group) (herein below, referred to as a carboxylic group-containing olefinic polymer) and an olefinic polymer having an epoxy group as a functional group (herein below, referred to as an epoxy group-containing olefinic polymer) are preferable in that favorable interlayer adhesion can be obtained therewith. Herein below, they are explained in order.

First, the carboxylic group-containing olefinic polymer is explained. The carboxylic group-containing olefinic polymer used in the invention is not specifically limited if it is an olefinic polymer containing a carboxylic group. Particularly preferably, it is a polymer of at least one compound selected from an aliphatic unsaturated hydrocarbon compound having 2 to 12 carbon atoms and an aromatic unsaturated hydrocarbon compound having 8 to 12 carbon atoms, or a hydrogenated molecule thereof, wherein the carboxylic group is contained in the terminal or side chain of a molecular chain.

The carboxylic group-containing olefinic polymer used in the invention may be produced according to a conventionally known method and used. For example, it can be obtained by copolymerization of at least one compound selected from an aliphatic unsaturated hydrocarbon compound having 2 to 12 carbon atoms and an aromatic unsaturated hydrocarbon compound having 8 to 12 carbon atoms and a compound having a carboxylic group and a carbon-carbon double bond or a graft polymerization of a polyolefin, preferably a polyolefin having a carbon-carbon double bond, with a compound having a carboxylic group and a carbon-carbon double bond. Examples of the compound having a carboxylic group and a carbon-carbon double bond include unsaturated carboxylic acid and anhydride thereof like (meth)acrylic acid, crotonic acid, maleic acid, fumaric acid, itaconic acid, citraconic acid, tetrahydrophthalic acid, maleic anhydride, itaconic anhydride, and tetrahydrophthalic anhydride; unsaturated carboxylic acid salt like lithium (meth)acrylate, sodium (meth)acrylate, potassium (meth)acrylate, magnesium (meth)acrylate, and sodium maleate, and; unsaturated carboxylic acid ester like methyl (meth)acrylate, ethyl (meth)acrylate, (meth)acrylate, n-propyl (meth)acrylate, i-propyl (meth)acrylate, n-butyl (meth)acrylate, i-butyl (meth)acrylate, t-butyl (meth)acrylate, 2-ethylhexyl (meth)acrylate, dodecyl (meth)acrylate, octadecyl (meth)acrylate, and dimethyl maleic acid, but not limited thereto.

As another method for synthesis, there is a method of radical polymerizing at least one compound selected from an aliphatic unsaturated hydrocarbon compound having 2 to 12 carbon atoms and an aromatic unsaturated hydrocarbon compound having 8 to 12 carbon atoms in the presence of a compound having a mercapto group and a carboxyl group. According to this method, a compound having a mercapto group and a carboxyl group functions as a chain transfer agent for polymerization so that an olefinic polymer having a carboxyl group in the molecular terminal is obtained.

Next, the epoxy group-containing olefinic polymer is explained. The epoxy group-containing olefinic polymer used in the invention is not specifically limited if it is an olefinic polymer containing an epoxy group. Particularly preferably, it is a polymer of at least one compound selected from an aliphatic unsaturated hydrocarbon compound having 2 to 12 carbon atoms and an aromatic unsaturated hydrocarbon compound having 8 to 12 carbon atoms, or a hydrogenated molecule thereof, wherein the epoxy group is contained in the terminal or side chain of a molecular chain.

The epoxy group-containing olefinic polymer used in the invention may be produced according to a conventionally known method and used. For example, it can be obtained by copolymerization of at least one compound selected from an aliphatic unsaturated hydrocarbon compound having 2 to 12 carbon atoms and an aromatic unsaturated hydrocarbon compound having 8 to 12 carbon atoms and a compound having an epoxy group and a carbon-carbon double bond or a graft polymerization of a polyolefin, preferably a polyolefin having a carbon-carbon double bond, with a compound having an epoxy group and a carbon-carbon double bond.

As yet another method, there is a method of epoxidizing a carbon-carbon double bond-containing olefinic polymer with a suitable oxidizing agent like hydrogen peroxide, cumen peroxide, formic acid peroxide, peracetic acid, perbenzoic acid, and methchloro perbenzoic acid. Specific examples of the carbon-carbon double bond-containing olefinic polymer used for the method described above include high density polyethylene, low density polyethylene, ultra low density polypropylene, polystyrene, polybutadiene, polyisoprene, an ethylene-propylene copolymer, hydrogenated polybutadiene, hydrogenated polyisoprene and also a block copolymer having a carbon-carbon double bond like a styrene-butadiene block copolymer, a styrene-isoprene block copolymer, and a styrene-butadiene-isoprene copolymer. It can be prepared according to a method conventionally known in the art, and for example it can be produced by a method including thermolysis of an olefinic polymer having no carbon-carbon double bond preferably at the temperature of 200°C or above to give an olefinic polymer having a carbon-carbon double bond at the terminal. Further, a conjugated polyene compound like polybutadiene and styrene-butadiene block copolymer in which hydrogenation ratio is not 100% can be also used as a carbon-carbon double bond-containing olefinic polymer. In particular, the latter is easily obtainable in a state in which plural carbon-carbon double bonds are contained in a main chain or a side chain. Thus, it is more suitable for obtaining an epoxy group-containing olefinic polymer in which the epoxy group is contained in a great amount.

The composition B used in the invention may be also added with known additives like an anti-oxidizing agent, a UV absorbent, or the like. They are explained herein below.

When an anti-oxidizing agent is added to the composition B used in the invention, the type of the agent is not specifically limited. However, preferred examples thereof include a phenol-based anti-oxidizing agent, a phosphorus-based anti-oxidizing agent, and a sulfur-based anti-oxidizing agent. Of these, the phenol-based anti-oxidizing agent is preferable. The alkyl-substituted phenol-based anti-oxidizing agent is particularly preferable.

Examples of the phenol-based anti-oxidizing agent include an acrylate compound like 2-t-butyl-6-(3-t-butyl-2-hydroxy-5-methylbenzyl)-4-methylphenylacrylat e and 2,4-di-t-amyl-6-(1-(3,5-di-t-amyl-2-hydroxyphenyl)ethyl)phenylacrylate, an alkyl-substituted phenol-based compound like 2,6-di-t-butyl-4-methylphenol, 2,6-di-t-butyl-4-ethylphenol, octadecyl-3-(3,5-)di-t-butyl-4-hydroxyphenyl)propionate, 2,2'-methylene-bis(4-methyl-6-t-butylphenol),
4,4'-butylidene-bis(4-methyl-6-t-butylphenol),
4,4'-butylidene-bis(6-t-butyl-m-cresol),
4,4'-thiobis(3-methyl-6-t-butylphenol),
bis(3-cyclohexyl-2-hydroxy-5-methylphenyl)methane, 3,9-bis(2-(3-(3-t-butyl-4-hydroxy-5-methylphenyl)propionyloxy)-1,1-dim ethylethyl)-2,4,8,10-tetraoxapsiro[5,5]undecane,
1,1,3-tris(2-methyl-4-hydroxy-5-t-butylphenyl)butane,
1,3,5-trimethyl-2,4,6-tris(3,5-di-t-butyl-4-hydroxy benzyl) benzene, tetrakis(methylene-3-(3',5'-di-t-butyl-4'-hydroxyphenyl)propionate)meth ane, and triethylene glycol bis(3-(3-t-butyl-4-hydroxy-5-methylphenyl)propionate), and a triazine group-containing phenol-based compound like 6-(4-hydroxy-3,5-di-t-butylanilino)-2,4-bis-octylthio-1,3,5-triazine, 6-(4-hydroxy-3,5-dimethylanilino)-2,4-bis-octylthio-1,3,5-triazine, 6-(4-hydroxy-3-methyl-5-t-butylanilino)-2,4-bis-octylthio-1,3,5-triazine, and 2-octylthio-4,6-bis-(3,5-di-t-butyl-4-oxyanilino)-1,3,5-triazine.

Examples of the phosphorus-based anti-oxidizing agent include a monophosphate compound like triphenylphosphate, diphenyl isodecylphosphate, phenyl diisodecylphosphate, tris(nonylphenyl)phosphate, tris(dinonylphenyl)phosphate, tris(2-1-butyl-4-methylphenyl)phosphate,
tris(cyclohexylphenyl)phosphate,
2,2-methylenebis(4,6-di-t-butylphenyl)octylphosphate, 9,10-dihydro-9-oxa-10-phosphaphenanthrene-10-oxide,
10-(3,5-di-t-butyl-4-hydroxybenzyl)-9,10-dihydro-9-oxa-10-phosphaphe nanthrene-10-oxide, and 10-decyloxy-9,10-dihydro-9-oxa-10-phosphaphenanthrene,and a diphosphate compound like 4,4'-butylidene-bis(3-methyl-6-t-butylphenyl-di-tridecylphosphate), 4,4'-isopropylidene-bis(phenyl-di-alkyl(C12-C15)phosphate), 4,4'-isopropylidene-bis(diphenylmonoalkyl(C12-C15)phosphate), 1,1,3-tris(2-methyl-4-di-tridecylphosphate-5-t-butylphenyl)butane, and tetrakis(2,4-di-t-butylphenyl)-4,4'-biphenylenephosphate. Of these, the monophosphate compound is preferable.

Examples of the sulfur-based anti-oxidizing agent include dilauryl 3,3'-thiodipropionate, distearyl 3,3'-thiodipropionate, lauryl stearyl 3,3thiodipropionate, pentaerythritol-tetrakis-(β-lauryl-thiopropionate), and 3,9-bis(2-dodecylthioethyl)-2,4,8,10-tetraoxaspiro[5,5]undecane.

The anti-oxidizing agent may be used either singly or in combination of two or more. The addition amount of the anti-oxidizing agent is 0.001 to 5% by mass, and preferably 0.01 to 1% by mass compared to the mass of the composition B. When the addition amount of the anti-oxidizing agent is less than 0.001% by mass, the effect may not be obtained at sufficient level. On the other hand, when it is more than 5% by mass, an excellent effect may not be obtained, either.

When a UV absorbent is added to the composition B used in the invention, the type of the agent is not specifically limited. Examples of the UV absorbent used in the invention include a benzotriazole UV absorbent like 2-(5-methyl-2-hydroxyphenyl)benzotriazole, 2-[2-hydroxy-3,5-bis(α,α'-dimethylbenzyl)phenyl]-2H-benzotriazole, 2-(3,5-di-t-butyl-2-hydroxyphenyl)benzotriazole,
2-(3-t-butyl-5-methyl-2-hydroxyphenyl)-5-chlorobenzotriazole, 2-(3,5-di-t-butyl-5-methyl-2-hydroxyphenyl)-5-chlorobenzotriazole, 2-(3,5-di-t-amyl-2-hydroxyphenyl) benzotriazole, and 2-(2'-hydroxy-5'-t-octylphenyl)benzotriazole, a hindered amine UV absorbent like 2,2,6,6-tetramethyl-4-piperidylbenzoate, bis(2,2,6,6-tetramethyl-4-piperidyl)sebacate,
bis(1,2,2,6,6-pentamethyl-4-piperidyl)-2-(3,5-di-t-butyl-4-hydroxybenzyl )-2-n-butylmalonic acid, and 4-(3-(3,5-di-t-butyl-4-hydroxyphenyl)propionyloxy)-1-(2-(3-(3,5-di-t-buty l-4-hydroxyphenyl)propionyloxy)ethyl)-2,2,6,6-tetramethylpiperidine, and a benzoate UV absorbent like 2,4-di-t-butylphenyl-3,5-di-t-butyl-4-hydroxybenzoate and hexadecyl-3,5-di-t-butyl-4-hydroxybenzoate. The addition amount of the UV absorbent is 0.001 to 5% by mass, and preferably 0.01 to 1% by mass compared to the mass of the composition B. When the addition amount of the UV absorbent is less than 0.001% by mass, the effect may not be obtained at sufficient level. On the other hand, when it is more than 5% by mass, an excellent effect may not be obtained, either. The UV absorbent may be also used in combination of two or more.

The composition B of the invention can be obtained by mixing polyolefin, an organometallic functional group-containing olefinic polymer, and a reactive functional group-containing olefinic polymer, and additives, if necessary, according to a known method. Specific examples of the mixing method include melt kneading using a mixing roll, a Plast mill, an extruder, or the like or dissolving the components of the composition B in an appropriate organic solvent and then removing the solvent. However, it is not specifically limited if is not against the main spirit of the invention.

Composition A contained in the laminate of the invention is explained herein below. The composition A is not specifically limited, if it contains polyvinyl acetal. Content thereof is, compared to the mass of the composition A, 45% by mass or more, preferably 50% by mass or more, and more preferably 60% by mass or more. When the content of polyvinyl acetal is lower than 45% by mass in the composition A, the physical characteristics inherent to the polyvinyl acetal may not be obtained.

Next, the polyvinyl acetal used in the invention is explained. The polyvinyl acetal is typically produced from a vinyl alcohol polymer as a reacting material. The vinyl alcohol polymer can be obtained by a common method, i.e., a vinyl ester monomer is polymerized and the resulting polymer is saponified. Examples of polymerizing the vinyl ester monomer include a conventionally known method like solution polymerization, bulk polymerization, suspension polymerization, and emulsion polymerization. Depending on polymerization method, the polymerization initiator like an azo initiator, a peroxide initiator, and a redox initiator is appropriately selected. The saponification may be carried out by alcoholysis or hydrolysis using a known alkali catalyst or a catalyst agent. Among them, the saponification reaction in which methanol is used as a solvent and caustic soda (NaOH) is used as a catalyst is most preferable, as it is convenient to carry out.

Examples of the vinyl ester monomer include vinyl formate, vinyl acetate, vinyl propionate, vinyl lactate, vinyl isolactate, vinyl pyvarate, vinyl versatate, vinyl caproate, vinyl caprylate, vinyl laurate, vinyl palimitate, vinyl stearate, vinyl oleate, and vinyl benzoate. Vinyl acetate is particularly preferable.

Further, when the vinyl ester monomer is polymerized, it may be copolymerized with other monomer if is not against the main spirit of the invention. Examples of other monomer include the compounds that are exemplified above as the compounds copolymerizable with the aliphatic unsaturated hydrocarbon compound having 2 to 12 carbon atoms and aromatic unsaturated hydrocarbon compound having 8 to 12 carbon atoms used for polymerization of the polyolefin used in the composition B or the composition C, or the aliphatic unsaturated hydrocarbon compound having 2 to 12 carbon atom and aromatic unsaturated hydrocarbon compound having 8 to 12 carbon atoms used for polymerization of the polyolefin used in the composition C within the range that the effect of the invention is not impaired (e.g., acrylic acid and a salt thereof, acrylate esters, methacrylic acid and a salt thereof, methacrylate esters) and the compound exemplified above as a compound having a carboxylic group and a carbon-carbon double bond, but not limited thereto. The monomer is generally used in ratio of less than 10 mol% compared to the vinyl ester monomer.

Viscosity average degree of polymerization of the vinyl alcohol polymer, which is used as a reacting material of the polyvinyl acetal used in the invention, is appropriately selected depending on use. However, it is preferably 150 to 3,000 and more preferably 200 to 2,000. When the viscosity average degree of polymerization of the vinyl alcohol polymer is less than 150, strength of the layer A tends to be insufficient. On the other hand, when it is more than 3,000, handlability tends to be poor at the time of molding the layer A.

The polyvinyl acetal used in the invention may be obtained by the following method, for example. First, an aqueous solution of vinyl alcohol polymer having concentration of 3 to 30% by mass is adjusted to the temperature range of 80 to 100°C and then the temperature is gradually cooled over 10 to 60 min. When the temperature is lowered to -10 to 30°C, an aldehyde and a catalyst are added and the acetalization is carried out for 30 to 300 min while maintaining constant temperature. After that, the reaction solution is increased to the temperature of 30 to 80°C over 30 to 200 min and maintained at the same temperature for 1 to 6 hours. Then, the reaction solution is preferably cooled to room temperature and washed with water. If necessary, it is neutralized by adding a neutralizing agent like alkali, washed with water, and dried to obtain the polyvinyl acetal used in the invention.

The catalyst used for the acetalization is not specifically limited, and both an organic acid and an inorganic acid can be used. Examples thereof include acetic acid, paratoluene sulfonic acid, nitric acid, sulfuric acid, and hydrochloric acid. Of these, hydrochloric acid, sulfuric acid, and nitric acid are preferably used. Hydrochloric acid is particularly preferably used.

The aldehyde used for the acetalization of the invention is not specifically limited. However, polyvinyl acetal acetalized with an aldehyde having 1 to 8 carbon atoms is preferably used. Examples of the aldehyde having 1 to 8 carbon atoms include formaldehyde, acetaldehyde, propionaldehyde, n-butyraldehyde, isobutyraldehyde, n-hexylaldehyde, 2-ethylbutyraldehyde, n-octylaldehyde, 2-ethylhexylaldehyde, and benzaldehyde. It may be used either singly or in combination of two or more. Of these, an aldehyde having 4 to 6 carbon atoms, in particular n-butyraldehyde is preferably used. In other words, as a polyvinyl acetal, polyvinyl butyral is particularly preferable.

Average degree of acetalization of the polyvinyl acetal is preferably 40 to 85 mol%, more preferably 48 to 82 mol%, and still more preferably 55 to 81 mol%. By using the polyvinyl acetal having the degree of acetalization within this range, excellent transparency can be obtained. Further, to achieve more preferably the purpose of the invention, the content of vinyl ester unit in the polyvinyl acetal (content of vinyl acetate unit, in general) is 0.01 to 30 mol%, preferably 0.05 to 15 mol%, and more preferably 0.1 to 5 mol%. Further, the content of vinyl alcohol unit is 10 to 50 mol%, preferably 12 to 40 mol%, and most preferably 15 to 35 mol%. Meanwhile, the degree of acetalization, content of vinyl ester unit, and content of vinyl alcohol unit are the value compared to the total of the degree of acetalization (content of vinyl acetal unit), content of vinyl ester unit, and content of vinyl alcohol unit.

The composition A used in the invention may be added with an anti-oxidizing agent, a UV absorbent, and other conventionally known additives. Examples of the anti-oxidizing agent include those exemplified above as the anti-oxidizing agent (phenol-based anti-oxidizing agent, phosphorus-based anti-oxidizing agent, sulfur-based anti-oxidizing agent, or the like) that can be added to the composition B, and the examples of the UV absorbent include those exemplified above as a UV absorbent that can be added to the composition B, but not limited thereto. Further, the addition amount is, in terms of each addition amount of an anti-oxidizing agent and a UV absorbent, 0.001 to 5% by mass, and preferably 0.01 to 1% by mass compared to the mass of the composition A.

The composition A used invention may also contain a plasticizer if it is not against the main spirit of the invention. Examples of the plasticizer that can be used include a carboxylic acid ester plasticizer like monocarboxylic acid ester and polycarboxylic acid ester, a phosphoric acid ester plasticizer, an organic phosphorus acid plasticizer and also carboxylic acid polyester, carbonate polyester, a polymer plasticizer like polyalkylene glycol, and an ester compound between hydrocarboxylic acid and polyhydric alcohol like castor oil. It can be appropriately selected depending on use. However, when a common laminate is produced by using them, a plasticizer which migrates from the layer A to the layer B or the layer C may impair the physical properties of a laminate (i.e., strength, interlayer adhesion, or transparency of the layer B or the layer C), and therefore it is often undesirable to use.

Examples of the monocarboxylic acid ester include a compound obtained by condensation between a monocarboxylic acid like butanoic acid, isobutanoic acid, hexanoic acid, 2-ethylhexanoic acid, heptanoic acid, octyl acid, 2-ethyl hexanoic acid, and lauric acid and a polyhydric alcohol like ethylene glycol, diethylene glycol, triethylene glycol, tetraethylene glycol, polyethylene glycol, and glycerin. Specific examples thereof include triethylene glycol di 2-ethylhexanoate, triethylene glycol diisobutanoate, triethylene glycol di 2-hexanoate, triethylene glycol di 2-ethylbutanoate, triethylene glycol dilaurate, ethylene glycol di 2-ethylhexanoate, diethylene glycol di 2-ethylhexanoate, tetraethylene glycol di 2-ethylhexanoate, tetraethylene glycol diheptanoate, PEG#400 di 2-ethylhexanoate, triethylene glycol mono 2-ethylhexanoate, and glycerin tri 2-ethylhexanoate. Herein, PEG#400 represents polyethylene glycol having average molecular weight of 350 to 450.

Examples of the polycarboxylic acid ester include a compound obtained by polycondensation between a polycarboxylic acid like adipic acid, succinic acid, azelaic acid, sebacic acid, phthalic acid, isophthalic acid, terephthalic acid, and trimethylic acid and an alcohol having 1 to 12 carbon atoms like methanol, ethanol, butanol, hexanol, 2-ethyl butanol, heptanol, octanol, 2-ethyl hexanol, decanol, dodecanol, butoxy ethanol, butoxyethoxy ethanol, and benzyl alcohol. Specific examples of the compound include dihexyl adipate, di-2-ethylhexyl adipate, diheptyl adipate, dioctyl adipate, di 2-ethylhexyl adipate, di(butoxyethyl)adipate, di(butoxyethoxyethyl)adipate, mono(2-ethylhexyl)adipate, dibutyl phthalate, dihexyl phthalate, di(2-ethylbutyl) phthalate, dioctyl phthalate, di(2-ethylhexyl) phthalate, benzylbutyl phthalate, and didodecyl phthalate.

Examples of the phosphoric acid plasticizer and phosphorus acid plasticizer include a compound obtained by polycondensation of phosphoric acid or phosphorus acid with an alcohol having 1 to 12 carbon atoms like methanol, ethanol, butanol, hexanol, 2-ethyl butanol, heptanol, octanol, 2-ethyl hexanol, decanol, dodecanol, butoxy ethanol, butoxyethoxy ethanol, and benzyl alcohol. Specific examples of the compound include trimethyl phosphate, triethyl phosphate, tripropyl phosphate, tributyl phosphate, tri(2-ethylhexyl) phosphate, tri(butoxyethyl) phosphate, and tri(2-ethylhexyl) phosphite.

Examples of the carboxylic acid poly ester plasticizer include a carboxylic acid polyester obtained by copolymerization of polycarboxylic acid like oxalic acid, malonic acid, succinic acid, adipic acid, suberic acid, sebacic acid, dodecane diacid, 1,2-cyclo hexane di carboxylic acid, 1,3-cyclo hexane dicarboxylic acid, and 1,4-cyclo hexane dicarboxylic acid and a polyhydric alcohol like ethylene glycol, diethylene glycol, triethylene glycol, tetraethylene glycol, 1,2-propylene glycol, 1,3-propylene glycol, 1,2-butylene glycol, 1,3-butylene glycol, 1,4-butylene glycol, 1,2-pentanediol, 1,5-pentanediol, 2,4-pentanediol, 1,2-hexanediol, 1,6-hexanediol, 3-methyl-1,5-pentanediol, 3-methyl-2,4-pentanediol, 1,2-heptanediol, 1,7-heptanediol, 1,2-octanediol, 1,8-octanediol, 1,2-nonanediol, 1,9-nonanediol, 2-methyl-1,8-octanediol, 1,2-decanediol, 1,10-decanediol, 1,2-dodecanediol, 1,12-dodecanediol, 1,2-cyclohexanediol, 1,3-cyclohexanediol, 1,4-cyclohexanediol, 1,2-bis(hydroxymethyl)cyclohexane, 1,3-bis(hydroxymethyl)cyclohexane, and 1,4-bis(hydroxymethyl)cyclohexane, and carboxylic acid polyester obtained by ring opening polymerization of a lactone compound like ε-caprolactone. The terminal structure of these carboxylic acid polyesters is not specifically limited. It may be either a hydroxyl group or a carboxyl group. Further, it may have an ester bond obtained by reacting the terminal hydroxyl group or the terminal carboxyl group with a monocarboxylic acid or a monohydric alcohol.

Examples of the carbonate polyester plasticizer include a carbonate polyester obtained by alternative copolymerization based on ester exchange of polyhydric alcohol like ethylene glycol, diethylene glycol, triethylene glycol, tetraethylene glycol, 1,2-propylene glycol, 1,3-propylene glycol, 1,2-butylene glycol, 1,3-butylene glycol, 1,4-butylene glycol, 1,2-pentanediol, 1,5-pentanediol, 2,4-pentanediol, 1,2-hexanediol, 1,6-hexanediol, 3-methyl-1,5-pentanediol, 3-methyl-2,4-pentanediol, 1,2-heptanediol, 1,7-heptanediol, 1,2-octanediol, 1,8-octanediol, 1,2-nonanediol, 1,9-nonanediol, 2-methyl-1,8-octanediol, 1,2-decanediol, 1,10-decanediol, 1,2-dodecanediol, 1,12-dodecanediol, 1,2-cyclohexanediol, 1,3-cyclohexanediol, 1,4-cyclohexanediol, 1,2-bis(hydroxymethyl)cyclohexane, 1,3-bis(hydroxymethyl)cyclohexane, and 1,4-bis(hydroxymethyl)cyclohexane and carbonate ester like dimethyl carbonate and diethyl carbonate. The terminal structure of the carbonate polyester compound is not specifically limited. However, it is preferably a carbonate ester group or a hydroxyl group.

Examples of the polyalkylene glycol plasticizer include a polymer obtained by ring opening polymerization of an alkylene oxide like ethylene oxide, propylene oxide, and butylenes oxide by using monohydric alcohol, polyhydric alcohol, and monocarboxylic acid, or polycarboxylic acid as an initiator.

According to the invention, the plasticizer may be used either singly or in combination of two or more. The use amount is not specifically limited. Compared to 100 parts by mass of the polyvinyl acetal contained in the composition A, it is used in an amount of 1 to 100 parts by mass, preferably 5 to 70 parts by mass, and most preferably 10 to 50 parts by mass. When the use amount of the plasticizer is less than 1 part by mass compared to 100 parts by mass of the polyvinyl acetal contained the composition A, the plasticizing effect may not be obtained at sufficient level. On the other hand, when it is more than 100 parts by mass, an excellent plasticizing effect may not be obtained, either.

When the laminate of the invention is used for application which requires suitable adjustment of adhesion with glass, for example, an intermediate film of a laminated glass, a solar cell module, or the like, it is preferable that the composition A used in the invention is added with an adhesive modifying agent. Examples of the adhesive modifying agent that can be used include those described in International Publication No. 03/033583, and an alkali metal salt and/or alkali earth metal salt of an organic acid is preferably added. In particular, potassium acetate and/or magnesium acetate is preferable. The addition amount is preferably 1 to 10,000 ppm, more preferably 5 to 1,000 ppm, and still more preferably 10 to 300 ppm compared to the mass of the composition A. The most suitable addition amount of the adhesive modifying agent varies depending on the additives used or the purpose of use. However, from the viewpoint of suitably controlling adhesion with a glass, it is generally controlled to 3 to 10 when, as a laminate of the invention, a laminate which has a surface in contact with glass is layer A is laminated with a glass is evaluated by Pummel test (described in International Publication No. 03/033583 or the like). When high resistance to penetration is required in particular, it is preferably adjusted to 3 to 6. When a high glass shatterproof property is required, it is preferably adjusted to 7 to 10. When a high glass shatterproof property is required, it is also useful not to add any adhesive modifying agent.

The composition A of the invention can be obtained by mixing polyvinyl acetal, and additives or a plasticizer, if necessary, according to a known method. Specific examples of the mixing method include melt kneading using a mixing roll, a plast mill, an extruder, or the like or dissolving the components of the composition A in an appropriate organic solvent and then removing the solvent. However, it is not specifically limited if is not against the main spirit of the invention.

Composition C used in the invention is explained herein below. The composition C used in the invention is not specifically limited, if it contains polyolefin. Content thereof is, compared to the mass of the composition C, 30% by mass or more, preferably 80% by mass or more, and more preferably 90% by mass or more. When the content of polyvinyl acetal is lower than 30% by mass in the composition C, the low water absorption property and various dynamic properties inherent to the polyolefin and the characteristics like sound proof property inherent to the block copolymer may be impaired.

The composition C used in the invention may be added with an anti-oxidizing agent, a UV absorbent, and other conventionally known additives. Examples of the anti-oxidizing agent include those exemplified above as the anti-oxidizing agent (phenol-based anti-oxidizing agent, phosphorus-based anti-oxidizing agent, sulfur-based anti-oxidizing agent, or the like) that can be added to the composition B, and the examples of the UV absorbent include those exemplified above as a UV absorbent that can be added to the composition B, but not limited thereto. Further, the addition amount is, in terms of each addition amount of an anti-oxidizing agent and a UV absorbent, 0.001 to 5% by mass, and preferably 0.01 to 1% by mass compared to the mass of the composition C.

The composition C of the invention can be obtained by mixing polyolefin, and additives or a plasticizer, if necessary, according to a known method. Specific examples of the mixing method include melt kneading using a mixing roll, a Plast mill, an extruder, or the like or dissolving the components of the composition C in an appropriate organic solvent and then removing the solvent. However, it is not specifically limited if is not against the main spirit of the invention.

The lamiante of the invention may contain two or more of the layer A, layer B, and layer C as long as it has a constitution in which the layer A and the layer B are laminated on each other or a constitution in which the layer A and the layer C are laminated on each other via the layer B. Further, when two or more layers are contained, they may the same or different from each other. Further, the laminate of the invention may also contain a layer other than those above (herein below, referred to as layer D). Specific examples of the layer D include a polyester layer, a polyamide layer, a polyimide layer, and a polycarbonate layer, but not limited thereto. Specific examples of the layer constitution in the laminate of the invention include layer A/layer B, layer A/layer B/layer A, layer A/layer B/layer A/layer B/layer A, layer B/layer A/layer B, layer A/layer B/layer B/layer A, layer A/layer B/layer C/layer B/layer A, layer A/layer B/layer D/layer B/layer A, and layer A/layer B/layer C, layer A/layer B/layer C/layer D/layer C/layer B/layer A, but not limited thereto.

Thickness of each layer is not specifically limited as long as the laminate of the invention has a constitution in which the layer A and the layer B are laminated on each other or a constitution in which the layer A and the layer C are laminated on each other via the layer B. However, thickness of the layer A, layer B, and layer C is 0.001 to 5 mm, preferably 0.01 to 3 mm, and most preferably 0.1 to 1.6 mm. When the laminate of the invention contains two or more layers, thickness of the layers may be the same or different from each other. Further, when the layer B functions as an adhesive layer, its thickness is not specifically limited either. However, it is 0.001 to 1 µm, preferably 0.005 to 0.7 µm, and most preferably 0.01 to 0.5 µm. When the laminate of the invention contains two or more layers of layer B as an adhesive layer, thickness of the layers may be the same or different from each other. Further, thickness of each layer may be either even or uneven. Even thickness is preferable.

In the laminate of the invention, the amount of an organometallic functional group contained in the layer B is not specifically limited. Even when the organometallic functional group contained in the organometallic functional group-containing olefinic polymer is a boron functional group, the amount of the boron functional group (based on the number of boron atoms) in the layer B is, although not specifically limited, preferably 0.1 to 1500 µeq/g, more preferably 0.5 to 700 µeq/g, and most preferably 1 to 500 µeq/g in terms of atom. When the amount of the boron functional group is less than 0.1 µeq/g, adhesion between the layer A and layer B may become insufficient. On the other hand, when the amount of the boron functional group is more than 1500 µeq/g, not only the adhesion between the layer A and layer B is not improved significantly but also the production cost of the boron functional group-containing olefinic polymer increases and the compatibility and adhesion between the boron functional group-containing olefinic polymer and the polyolefin may be reduced.

Further, when the organometallic functional group contained in the organometallic functional group-containing olefinic polymer is a silicon atom, the amount of the silicon functional group (based on the number of silicon atoms) contained in the layer B is not specifically limited. Although not specifically limited, it is preferably 0.1 to 1500 µeq/g, more preferably 0.5 to 700 µeq/g, and most preferably 1 to 500 µeq/g in terms of atom. When the amount of the silicon functional group is less than 0.1 µeq/g, adhesion between the layer A and layer B may become insufficient. On the other hand, when the amount of the silicon functional group is more than 1500 µeq/g, not only the adhesion between the layer A and layer B is not improved significantly but also the production cost of the silicon functional group-containing olefinic polymer increases and the compatibility and adhesion between the silicon functional group-containing olefinic polymer and the polyolefin may be reduced.

In the laminate of the invention, the amount of a reactive functional group contained in the layer B is not specifically limited. Even when the a reactive functional group contained in the a reactive functional group-containing olefinic polymer is a carboxylic group, the amount of the carboxylic group in the layer B is, although not specifically limited, preferably 1 to 1500 µeq/g, more preferably 2 to 700 µeq/g, and most preferably 3 to 500 µeq/g in terms of atom. In the detailed description, the amount of the carboxylic group indicates a value calculated in view of the carbonyl group included in the carboxylic group. When the amount of the carboxylic group is less than 1 µeq/g, adhesion between the layer A and layer B may become insufficient. On the other hand, when the amount of the carboxylic group is more than 1500 µeq/g, not only the adhesion between the layer A and layer B is not improved significantly but also the production cost of carboxylic group-containing olefinic polymer increases and the compatibility and adhesion between the carboxylic group-containing olefinic polymer and the polyolefin may be reduced.

Further, when the reactive functional group contained in the reactive functional group-containing olefinic polymer is an epoxy group, the amount of an epoxy group contained in the layer B is not specifically limited. However, it is preferably 1 to 1500 µeq/g, more preferably 2 to 700 µeq/g, and most preferably 3 to 500 µeq/g in the layer B. When the amount of the epoxy group is less than 1 µeq/g, adhesion between the layer A and layer B may become insufficient. On the other hand, when the amount of the epoxy group is more than 1500 µeq/g, not only the adhesion between the layer A and layer B is not improved significantly but also the production cost of the epoxy group-containing olefinic polymer increases and the compatibility and adhesion between the epoxy group-containing olefinic polymer and the polyolefin may be reduced.

The method for producing the laminate of the invention is not specifically limited, and it can be produced by a known method like coextrusion molding, multilayer injection molding, and dry lamination. For example, for a laminate having a constitution in which the layer A and layer B are laminated on each other, it is preferably produced by coextrusion molding, and it can be carried out by lamination inside a die in which components of each layer are brought into contact with each other inside a die or lamination outside a die in which they are brought into contact with each other outside a die. The extrusion temperature can be appropriately selected, but is 150 to 300°C, or preferably 180 to 250°C. For a case of a laminate having a constitution in which the layer A and layer C are laminated on each other via the layer B, it can be produced by preparing in advance the layer A and/or the layer C by extrusion molding or the like, forming the layer B on the surface of the layer A and/or the layer C by casting or the like, and performing dry lamination of the layers.

The mass ratio of (the polyolefin)/(the organometallic functional group-containing olefinic polymer) of the composition B used in the laminate of the invention is 0/100 to 99.95/0.05. The ratio can be appropriately selected depending on type of the polyolefin or the types of the organometallic functional group-containing olefinic polymer, and various physical properties required for the laminate to be obtained. However, as described in the following examples, even when the addition amount of the organometallic functional group-containing olefinic polymer is very small in the composition B, high adhesion is exhibited. Thus, the use amount of an organometallic functional group-containing olefinic polymer, which is generally expensive than polyolefins and has a possibility of reducing the transparency of the layer B, can be reduced, and therefore desirable. Further, the mass ratio of (the polyolefin)/(the reactive functional group-containing olefinic polymer) of the composition B used in the laminate of the invention is 0/100 to 99.9/0.1, and the ratio can be appropriately selected depending on type of the polyolefin or the types of the reactive functional group-containing olefinic polymer, and various physical properties required for the laminate to be obtained. However, as described in the following examples, even when the addition amount of the reactive functional group-containing olefinic polymer is very small in the composition B, high adhesion is exhibited.

Transparency of the laminate of the invention is not specifically limited. However, when the haze of a laminated glass obtained by inserting the laminate of the invention between two glass plates is used as an indicator, the transparency is preferably 5% or less, more preferably 3% or less, and still more preferably 1% or less.

The laminate of the invention is preferably used as an intermediate film of a laminated glass. Herein below, it is explained in greater detail. When the laminate of the invention is used as an intermediate film of a laminated glass, the glass used therefor is not specifically limited, and examples of the glass that can be used include an inorganic glass like a float plate glass, a polished plate glass, a figure plate glass, a wire mesh plate glass, and a heat-absorbing plate glass and a known organic glass. They can be colorless or colored, and also transparent or opaque. The glass may be used either singly or in combination of two or more. Further, although not specifically limited, the thickness of the glass is preferably 100 mm or less.

When the laminate of the invention is used as an intermediate film of a laminated glass, constitution of the laminate is not specifically limited if it is not against the main spirit of the invention. However, it is preferable that a suitable layer having adhesiveness with a glass is present on the outermost layer of the laminate of the invention. In particular, when an inorganic glass is used as a glass, the outermost layer is preferably the layer A having excellent adhesiveness with a glass. Examples of the laminate of the invention in which the outermost layer is the layer A include layer A/layer B/layer A and layer A/layer B/layer C/layer B/layer A.

When the laminate of the invention is used as an intermediate film of a laminated glass, shape of the outermost layer of the laminate is not specifically limited. However, considering the handlability (foamability) at the time of laminating with a glass, a laminate having a concave/convex structure formed on the outermost surface of the laminate by a known method like meltfracture and embossing is preferable.

Further, as used as a filler for a solar cell module, the laminate of the invention is preferably used in a field in which a vibration damping property is required, in particular, a building integrated photovoltaic solar cell like BIPV. It is explained herein below.

The type of the solar cell used for the solar cell module of the invention is not specifically limited. Examples thereof include a crystal type like monocrystal silicone and polycrystal silicone, a thin film silicone type like amorphous silicone and a laminate of amorphous silicone and a polycrystal thin film, a thin film type like a chemical semi-conductor type using CIS, CIGS, CdTe, or GaAs, and an organic solar cell type.

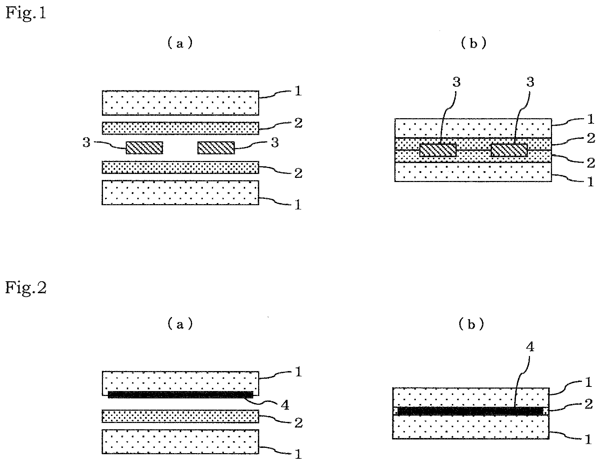

When the solar cell used in the solar cell module of the invention is a crystal type, a constitution shown in FIG. 1(b), which is obtained by overlaying the crystal type solar cell 3, the filler 2, a glass and a back sheet 1 or the like (herein below, referred to as a glass) as shown in FIG. 1(a) and laminating them, can be mentioned. When at least one of the filler 2 used in this case is the laminate of the invention, it is also possible to use other fillers, for example, fillers consisting of a known composition of crosslinkable ethylene-vinyl acetate copolymer or composition consisting of plasticized polyvinyl acetal.

Further, when the solar cell used in the solar cell module of the invention is a thin film type, a constitution shown in FIG. 2(b), which is obtained by overlaying a surface glass on which the solar cell 4 is deposited (it may also contain a transparent electrode layer containing ITO, ATO, or FTO) as shown in FIG. 2(a), the filler 2, and the glass 1 and laminating them, can be mentioned. Similar to the above, as filler 2, fillers consisting of a composition of crosslinkable ethylene-vinyl acetate copolymer or composition consisting of plasticized polyvinyl acetal can be also used in combination, if necessary.

The glass used in the invention is not specifically limited, and examples of the glass that can be used include an inorganic glass like a float plate glass, a polished plate glass, a figure plate glass, a wire mesh plate glass, and a heat-absorbing plate glass and a known organic glass. Further, the back sheet is not specifically limited either, but those having excellent weatherability and low water permeability are preferably used. For example, a polyester film, a fluoro-resin film, a laminate thereof, and the film laminated with an inorganic film can be used.

The solar cell module of the invention can be further combined with a known frame, a junction box, a sealing material, an attached jig and board, an anti-reflection film, various facilities using solar energy, a gutter structure, or the like.

The laminated glass and the solar cell module of the invention can be produced according to a conventionally known method, and examples include a method of using a vacuum laminator, a method of using a vacuum bag, a method of using a vacuum ring, and a method of using nip roll. Further, a method of introducing to an autoclave process after pre-compression can be also carried out.

When a vacuum laminator is used, the lamination is carried out by using a known apparatus used for production of a solar cell under the reduced pressure of 1 to 30000 Pa, and temperature of 100 to 200°C, in particular 130 to 160°C. Further, the method of using a vacuum bag or a vacuum ring is described in the detailed description of European Patent No. 1 235 683, and the lamination is carried out under the pressure of about 20000 Pa, and temperature of 130 to 145°C, for example.

When a nip roll is used, a method of carrying out the first pre-compression at the temperature lower than the flow beginning temperature of the plasticized polyvinyl acetal resin and an additional pre-compression at the temperature close to the flow beginning temperature can be mentioned. For example, it is heated to 30 to 70°C by using an infrared heater or the like, released from the roll, further heated to 50 to 120°C, and compressed with a roll for adhesion or pre-adhesion.

The autoclave process which is additionally carried out after the pre-compression is carried out, for example, under the pressure of about 1 to 1.5 MPa, at the temperature of 130 to 145°C for 0.5 to 2 hours, although it may vary depending on thickness and constitution of a module and a laminated glass.

### EXAMPLES

Herein below, the invention is explained in greater detailed in view of the examples, but the invention is not limited to them. Further, as used in the following examples, the term "%" and "parts" means "% by mass" and "parts by mass", respectively, unless specifically described otherwise.

### (NMR analysis of polyolefin, organometallic functional group-containing olefinic polymer, and reactive functional group-containing olefinic polymer)

Polyolefin-1,2,4,8,9, organometallic functional group-containing olefinic polymer-1,2,4, and reactive functional group-containing olefinic polymer-1,3 are measured by ¹H-NMR spectrum using deuterated chloroform as a solvent, polyolefin-3, organometallic functional group-containing olefinic polymer-3, and, reactive functional group-containing olefinic polymer-2,4 are measured by ¹H-NMR spectrum using deuterated paraxylene as a solvent. Amount of the carbon-carbon double bond is calculated for each polyolefin, amount of the organometallic functional group is calculated for the organometallic functional group-containing olefinic polymer, and amount of the reactive functional group is calculated for the reactive functional group-containing olefinic polymer.

### (Weight average molecular weight)

Weight average molecular weight of polyolefin-1,2,4,8,9, organometallic functional group-containing olefinic polymer-1,2,4, and reactive functional group-containing olefinic polymer-1,3 was measured by GPC measurement using tetrahydrofuran as a solvent, and weight average molecular weight of polyolefin-3, organometallic functional group-containing olefinic polymer-3, and reactive functional group-containing olefinic polymer-2,4 was measured by GPC measurement using ortho dichlorobenzene as a solvent in view of polystyrene as a standard. Herein below, condition for GPC measurement is described.
Apparatus: SYSTEM 11 (manufactured by Showa Denko K.K.)
Column: two columns of MIXED-C (manufactured by Polymer Laboratories, Ltd.)
Mobile phase: tetrahydrofuran or ortho dichlorobenzene
Flow amount: 1.0 mL/min
Temperature: 40°C
Concentration: 0.1%
Injection amount: 100 µL
Detector: RI
Standards: polystyrene (manufactured by Polymer Laboratories, Ltd.)

### Synthetic example 1

### (Synthesis of carbon-carbon double bond-containing block copolymer)

To a 200 L pressure resistant vessel flushed with dry nitrogen, 60 kg of cyclohexane and 35 g of sec-butyl lithium as a polymerization initiator were added followed by addition of 2.9 kg of styrene. After polymerization at 50 to 52°C, 0.17 kg of THF was added and 26.2 kg of butadiene and 2.9 kg of styrene were added in order for polymerization. As a result, a styrene-butadiene-styrene type block copolymer was obtained. The block copolymer obtained was hydrogenated by using Pd/C (palladium carbon) in cyclohexane with hydrogen pressure of 2 MPa and reaction temperature of 100°C to obtain the carbon-carbon double bond-containing block copolymer (polyolefin-1). The polyolefin-1 obtained has a weight average molecular weight of 100,400, styrene content of 18% by mass, and hydrogenation ratio of 97 mol% (content of the carbon-carbon double bond: 450 µeq/g). The results are shown in the Table 1.

### Synthetic example 2

### (Synthesis of carbon-carbon double bond-containing block copolymer)

To a 200 L pressure resistant vessel flushed with dry nitrogen, 60 kg of cyclohexane and 16.6 g of sec-butyl lithium as a polymerization initiator were added followed by addition of 1.45 kg of styrene. After polymerization at 50 to 52°C, 0.48 kg of THF was added and 13.8 kg of isoprene and 1.45 kg of styrene were added in order for polymerization. As a result, a styrene-isoprene-styrene type block copolymer was obtained. The block copolymer obtained was hydrogenated by using Pd/C in cyclohexane with hydrogen pressure of 2 MPa and reaction temperature of 100°C to obtain the carbon-carbon double bond-containing block copolymer (polyolefin-2). The polyolefin-2 obtained has a weight average molecular weight of 83,000, styrene content of 16% by mass, and hydrogenation ratio of 92 mol% (content of the carbon-carbon double bond: 1,000 µeq/g). The results are shown in the Table 1.

### Synthetic example 3

### (Synthesis of ultra low density polyethylene having carbon-carbon double bond in terminal)

To a separable flask, 200 g of ultra low density polyethylene having weight average molecular weight of 230,000 was added and heated for 30 min at 250°C under vacuum. The temperature was further increased to 340°C and heated for 2 hours to obtain the ultra low density polyethylene having carbon-carbon double bond in the terminal (polyolefin-3). The polyolefin-3 obtained has a weight average molecular weight of 80,000 and the content of the carbon-carbon double bond was 60 µeq/g. The results are shown in the Table 1.

### Synthetic example 4

### (Synthesis of carbon-carbon double bond-containing block copolymer)

The carbon-carbon double bond-containing block copolymer (polyolefin-4) was obtained in the same manner as the Synthetic example 1 except that the reaction time for hydrogenation is extended and the hydrogenation ratio is 99 mol% (content of the carbon-carbon double bond: 150 µeq/g). The results are shown in the Table 1.

**[Table 1]**

| | Structure | Weight average molecular weight | Amount of double bond (µeq/g) |
|---|---|---|---|
| Polyolefin-1 | Styrene-butadiene block copolymer (styrene 18% by mass) | 100,400 | 450 |
| Polyolefin-2 | Styrene-isoprene block copolymer (styrene 16% by mass) | 83,000 | 1,000 |
| Polyolefin-3 | Ultra low density polyethylene | 80,000 | 60 |
| Polyolefin-4 | Styrene-butadiene block copolymer (styrene 18% by mass) | 100,400 | 150 |

### Synthetic example 5

### (Synthesis of organometallic functional group-containing olefinic polymer-1)

The polyolefin-1 synthesized from the Synthetic example 1 was supplied to a bi-axial extruder at the rate of 7 kg/hour while the inlet was flushed with nitrogen. Thereafter, a 29/71 (mass ratio) mixture liquid of borane-triethylamine complex and 1,3-butane diol borate ester was supplied at the rate of 0.6 kg/hour via the liquid feeder 1 and 1,3-butane diol was supplied at the rate of 0.4 kg/hour via the liquid feeder 2 and then continuously kneaded. During the kneading, the pressure was controlled so that the gauge of the vent 1 and the vent 2 is about 20 mmHg. As a result, the organometallic functional group-containing olefinic polymer-1 (organometallic functional group: 1,3-butane diol borate ester group) was yielded from the discharger at the rate of 7 kg/hour. The results are shown in the Table 2.

Meanwhile, constitution and operation condition of the bi-axial extruder used for the reaction are as follows.
Unidirectional biaxial extruder TEM-35B (manufactured by Toshiba machine)
Screw diameter: 37 mmϕ
L/D: 52 (15 block)
Liquid feeder: C3 (liquid feeder 1), C11 (liquid feeder 2)
Vent position: C6, C14
Screw constitution: seal ring is used between C5 and C6, C10 and C1, and C12 position

| Temperature setting: | C1 water cooling |
|---|---|
| | C2 to C3 200°C |
| | C4 to C15 250°C |
| | Die 250°C |

Screw revolution number: 400 rpm

### Synthetic example 6

### (Synthesis of organometallic functional group-containing olefinic polymer-2)

The polyolefin-2 synthesized from the Synthetic example 2 was supplied to a bi-axial extruder at the rate of 6 kg/hour while the inlet was flushed with nitrogen. Thereafter, a 29/71 (mass ratio) mixture liquid of borane-triethylamine complex and 1,3-butane diol borate ester was supplied at the rate of 1.2 kg/hour via the liquid feeder 1 and propylene glycol was supplied at the rate of 0.6 kg/hour via the liquid feeder 2 and then continuously kneaded. During the kneading, the pressure was controlled so that the gauge of the vent 1 and the vent 2 is about 20 mmHg. As a result, the organometallic functional group-containing olefinic polymer-2 (organometallic functional group: mixture of a 1,3-butane diol borate ester group and a boronic acid propylene glycol ester group) was yielded from the discharger at the rate of 6 kg/hour. The results are shown in the Table 2. Meanwhile, the constitution and operation condition of the bi-axial extruder used for the reaction are the same as those of the Synthetic example 5.

### Synthetic example 7

### (Synthesis of organometallic functional group-containing olefinic polymer-3)

To a separable flask equipped with a condenser, 30 g of the polyolefin-3 obtained from the Synthetic example 3, 300 mg of a borane-pyridine complex, 2.25 g of tributyl borate, and 50 g of decalin were added and flushed with nitrogen followed by reaction for 3 hours at 190°C. After cooling to room temperature, the gel type polyethylene obtained was washed well with a mixture solvent of methanol and acetone (1 : 1), and further washed with a mixture solvent of acetone and water (1 : 1) followed by drying to obtain the organometallic functional group-containing olefinic polymer-3 (organometallic functional group: boronic acid group). The results are shown in the Table 2.

### Synthetic example 8

### (Synthesis of organometallic functional group-containing olefinic polymer-4)

To a 200 L pressure resistant vessel flushed with dry nitrogen, 60 kg of cyclohexane, 3 kg of styrene and 9 g of sec-butyl lithium were added and reacted at 50°C. Then, after increasing the temperature to 70°C, 5.9 kg of 1,3-butadiene was added and 30 minutes later 3 kg of styrene was added. When the reaction is completed, 0.12 kg of 1,3-butadiene was added for further reaction and 41 g of methyl triphenoxysilane was added and reacted for 30 min. After the reaction, the reaction solution was cooled to room temperature, collected from the reaction vessel, and added to water. The solvent was then removed by vapor distillation to obtain the organometallic functional group-containing olefinic polymer-4 (organometallic functional group: methyl diphenoxysilyl group). The results are shown in the Table 2.

**[Table 2]**

| | Type of organometallic functional group | Amount of organometallic functional group (µeq/g) | Weight average molecular weight |
|---|---|---|---|
| Organometallic functional group-containing olefinic polymer-1 | Boronic acid (1,3-butanediol) ester group | 210 | 100,400 |
| Organometallic functional group-containing olefinic polymer-2 | Boronic acid (1,3-butanediol) ester group | 360 | 83,000 |
| | Boronic acid (propylene glycol) ester group | 270 | |
| Organometallic functional group-containing olefinic polymer-3 | Boronic acid group | 35 | 80,000 |
| Organometallic functional group-containing olefinic polymer-4 | Methyl diphenoxy silyl group | 17 | 130,000 |

### (Production of polyvinyl acetal)

To a 10 L (liter) glass vessel equipped with a reflux condenser, a thermometer, and an anchor type stirring wing, 8100 g of ion exchange water and 660 g of polyvinyl alcohol (PVA-1) (viscosity average degree of polymerization: 1700, saponification degree: 99 mol%) (PVA concentration: 7.5%) and completely dissolved by increasing the temperature to 95°C. Then, under stirring at 120 rpm, the mixture was gradually cooled to 5°C over about 30 min and added with 384 g of butyraldehyde and 540 mL of 20% hydrochloric acid for performing the butyralization for 150 min. The temperature was increased to 50°C for 60 min, maintained at 50°C for 120 min, and then cooled to room temperature. The precipitated resin was washed with ion exchange water, added with an excess amount of an aqueous solution of sodium hydroxide, washed again, and dried to obtain polyvinyl butyral (PVB-1). The PVB-1 obtained has butyralization degree (average acetalation degree) of 69 mol%, vinyl acetate group content of 1 mol%, and vinyl alcohol group content of 30 mol%. The butyralization degree of PVB-1 and the content of residual vinyl acetate group were measured according to JIS K6728.

### (Production of Composition A-1)

40 g of PVB-1, 16 g of polyester diol (a copolymer containing adipic acid and an excess amount of 3-methyl-1,5-pentanediol compared to adipic acid, number average molecular weight based on hydroxy value = 500), 0.12 g of 2-(3,5-di-t-butyl-2-hydroxyphenyl)benzotriazole, 0.04 g of potassium acetate, and 0.05 g of 2,6-di-t-butyl-4-methylphenol were melt-kneaded by a laboplast mill (150°C, 60 rpm, 5 min) to obtain the Composition A-1. The results are shown in the Table 3.

### (Production of Composition A-2)

40 g of PVB-1 and 0.05 g of 2,6-di-t-butyl-4-methylphenol were melt-kneaded by a laboplast mill (180°C, 60 rpm, 5 min) to obtain the Composition A-2. The results are shown in the Table 3.

### (Production of Composition A-3)

The Composition A-3 was obtained in the same manner as the Composition A-1 except that triethylene glycol di 2-ethylhexanoate is used instead of polyester diol. The results are shown in the Table 3.

**[Table 3]**

| | PVB-1 | Plasticizer | UV absorbent*³ | Potassium acetate | Anti-oxidizing agent*⁴ |
|---|---|---|---|---|---|
| Composition A-1 | 40 g | Polyester diol*¹ (16 g) | 0.12 g | 0.04 g | 0.05 g |
| Composition A-2 | 40 g | - | - | - | 0.05 g |
| Composition A-3 | 40 g | 3G8*² (16 g) | 0.12 g | 0.04 g | 0.05 g |

| | | | | | |
|---|---|---|---|---|---|
| *1: Polyester diol obtained by copolymerization of adipic acid and 3-methyl-1,5-pentane diol *2: Triethylene glycol di 2-ethyl hexanoate *3: 2-(3,5-Di-t-butyl-2-hydroxyphenyl)benzotriazole *4: 2,6-Di-t-butyl-4-methylphenol | | | | | |

### (Production of Composition B-1)

40 g of polyolefin-4, 0.4 g of the organometallic functional group-containing olefinic polymer-1, and 0.05 g of 2,6-di-t-butyl-4-methylphenol were melt-kneaded by a laboplast mill (200°C, 60 rpm, 5 min) to obtain the Composition B-1. The amount of the organometallic functional group in the Composition B-1 was 2.1 µeq/g in terms of boron atom. The results are shown in the Table 4.

### (Production of Composition B-2)

The Composition B-2 was obtained in the same manner as the Composition B-1 except that the amount of organometallic functional group-containing olefinic polymer-1 used was changed to 1.2 g. The amount of the organometallic functional group in the Composition B-2 was 6.1 µeq/g in terms of boron atom. The results are shown in the Table 4.

### (Production of Composition B-3)

The Composition B-3 was obtained in the same manner as the Composition B-1 except that the amount of organometallic functional group-containing olefinic polymer-1 used was changed to 4 g. The amount of the organometallic functional group in the Composition B-3 was 19 µeq/g in terms of boron atom. The results are shown in the Table 4.

### (Production of Composition B-4)

The Composition B-4 was obtained in the same manner as the Composition B-1 except that the amount of organometallic functional group-containing olefinic polymer-1 used was changed to 0.04 g. The amount of the organometallic functional group in the Composition B-4 was 0.21 µeq/g in terms of boron atom. The results are shown in the Table 4.

### (Production of Composition B-5)

The Composition B-5 was obtained in the same manner as the Composition B-1 except that the organometallic functional group-containing olefinic polymer-2 was used instead of the organometallic functional group-containing olefinic polymer-1. The amount of the organometallic functional group in the Composition B-5 was 6.2 µeq/g in terms of boron atom. The results are shown in the Table 4.

### (Production of Composition B-6)

The Composition B-6 was obtained in the same manner as the Composition B-5 except that the amount of organometallic functional group-containing olefinic polymer-2 used was changed to 1.2 g. The amount of the organometallic functional group in the Composition B-6 was 18 µeq/g in terms of boron atom. The results are shown in the Table 4.

### (Production of Composition B-7)

The Composition B-7 was obtained in the same manner as the Composition B-5 except that the amount of organometallic functional group-containing olefinic polymer-2 used was changed to 4 g. The amount of the organometallic functional group in the Composition B-7 was 57 µeq/g in terms of boron atom. The results are shown in the Table 4.

### (Production of Composition B-8)

The Composition B-8 was obtained in the same manner as the Composition B-6 except that polypropylene (manufactured by Japan Polypropylene Corporation, Novatec PP) was used instead of the polyolefin-4. The amount of the organometallic functional group in the Composition B-8 was 18 µeq/g in terms of boron atom. The results are shown in the Table 4.

### (Production of Composition B-9)

The Composition B-9 was obtained in the same manner as the Composition B-2 except that the organometallic functional group-containing olefinic polymer-3 was used instead of the organometallic functional group-containing olefinic polymer-1. The amount of the organometallic functional group in the Composition B-9 was 1.0 µeq/g in terms of boron atom. The results are shown in the Table 4.

### (Production of Composition B-10)

The Composition B-10 was obtained in the same manner as the Composition B-9 except that polypropylene (manufactured by Japan Polypropylene Corporation, Novatec PP) was used instead of the polyolefin-4. The amount of the organometallic functional group in the Composition B-10 was 1.0 µeq/g in terms of boron atom. The results are shown in the Table 4.

### (Production of Composition B-11)

The Composition B-11 was obtained in the same manner as the Composition B-3 except that the organometallic functional group-containing olefinic polymer-4 was used instead of the organometallic functional group-containing olefinic polymer-1. The amount of the organometallic functional group in the Composition B-11 was 1.5 µeq/g in terms of boron atom. The results are shown in the Table 4.

### (Production of Composition B-12)

40 g of organometallic functional group-containing olefinic polymer-2 and 0.05 g of 2,6-di-t-butyl-4-methylphenol were melt-kneaded by a laboplast mill (200°C, 60 rpm, 5 min) to obtain the Composition B-12. The amount of the organometallic functional group in the Composition B-12 was 630 µeq/g in terms of boron atom. The results are shown in the Table 4.

### (Production of Composition B-13)

The Composition B-13 was obtained in the same manner as the Composition B-1 except that the amount of the organometallic functional group-containing olefinic polymer-1 used was changed to 0.004 g. The amount of the organometallic functional group in the Composition B-13 was 0.021 µeq/g in terms of boron atom. The results are shown in the Table 4.

### (Production of Composition B-14)

The Composition B-14 was obtained by melt-kneading 40 g of polyolefin-5 (polystyrene-polyisoprene-polystyrene tri-block copolymer (polyisoprene part is completely hydrogenated), total content of polystyrene part = 12%, glass transition temperature = -32°C, tanδ peak temperature = -17°C, MFR value (ASTM D1238, load of 2.16 kg) is 0.5 g/10 min at 190°C, tanδ at -20°C = 1.0, tanδ at 0°C = 0.8, tanδ at 20°C = 0.3), 0.4 g of organometallic functional group-containing olefinic polymer-1, and 0.05 g of 2,6-di-t-butyl-4-methylphenol by using a laboplast mill (200°C, 60 rpm, 5 min). The amount of the organometallic functional group in the Composition B-14 was 2.1 µeq/g in terms of boron atom. The results are shown in the Table 4.

### (Production of Composition B-15)

The Composition B-15 was obtained by melt-kneading 40 g of polyolefin-6 (polystyrene-polyisoprene-polystyrene tri-block copolymer (polyisoprene part is completely hydrogenated), total content of polystyrene part = 22%, glass transition temperature = -12°C, tanδ peak temperature = -5°C, MFR value (ASTM D1238, load of 2.16 kg) is 0.7 g/10 min at 190°C, tanδ at -20°C = 0.15, tanδ at 0°C = 1.05, tanδ at 20°C = 0.4), 0.4 g of organometallic functional group-containing olefinic polymer-1, and 0.05 g of 2,6-di-t-butyl-4-methylphenol by using a laboplast mill (200°C, 60 rpm, 5 min). The amount of the organometallic functional group in the Composition B-15 was 2.1 µeq/g in terms of boron atom. The results are shown in the Table 4.

### (Production of Composition B-16)

The Composition B-16 was obtained by melt-kneading 40 g of polyolefin-7 (polystyrene-polyisoprene-polystyrene tri-block copolymer (polyisoprene part is not hydrogenated), total content of polystyrene part = 20%, glass transition temperature = -12°C, tanδ peak temperature = -1°C, MFR value (ASTM D 1238, load of 2.16 kg) is 3.8 g/10 min at 190°C, tanδ at -20°C = 0.08, tanδ at 0°C = 1.05, tanδ at 20°C = 0.9), 0.4 g of organometallic functional group-containing olefinic polymer-1, and 0.05 g of 2,6-di-t-butyl-4-methylphenol by using a laboplast mill (200°C, 60 rpm, 5 min). The amount of the organometallic functional group in the Composition B-16 was 2.1 µeq/g in terms of boron atom. The results are shown in the Table 4.

**[Table 4]**

| | Polyolefin | Organometallic functional group-containing olefinic polymer | Anti-oxidizing agent*¹ | Amount of organometallic functional group (µeq/g) |
|---|---|---|---|---|
| Composition B-1 | Polyolefin-4 (40 g) | Organometallic functional group-containing olefinic polymer-1 (0.4 g) | 0.05 g | 2.1 |
| Composition B-2 | Polyolefin-4 (40 g) | Organometallic functional group-containing olefinic polymer-1 (1.2 g) | 0.05 g | 6.1 |
| Composition B-3 | Polyolefin-4 (40 g) | Organometallic functional group-containing olefinic polymer-1 (4 g) | 0.05 g | 19 |
| Composition B-4 | Polyolefin-4 (40 g) | Organometallic functional group-containing olefinic polymer-1 (0.04 g) | 0.05 g | 0.21 |
| Composition B-5 | Polyolefin-4 (40 g) | Organometallic functional group-containing olefinic polymer-2 (0.4 g) | 0.05 g | 6.2 |
| Composition B-6 | Polyolefin-4 (40 g) | Organometallic functional group-containing olefinic polymer-2 (1.2 g) | 0.05 g | 18 |
| Composition B-7 | Polyolefin-4 (40 g) | Organometallic functional group-containing olefinic polymer-2 (4 g) | 0.05 g | 57 |
| Composition B-8 | Novatec PP (40 g) | Organometallic functional group-containing olefinic polymer-2 (1.2 g) | 0.05 g | 18 |
| Composition B-9 | Polyolefin-4 (40 g) | Organometallic functional group-containing olefinic polymer-3 (1.2 g) | 0.05 g | 1.0 |
| Composition B-10 | Novatec PP (40 g) | Organometallic functional group-containing olefinic polymer-3 (1.2 g) | 0.05 g | 1.0 |
| Composition B-11 | Polyolefin-4 (40 g) | Organometallic functional group-containing olefinic polymer-4 (4 g) | 0.05 g | 1.5 |
| Composition B-12 | - | Organometallic functional group-containing olefinic polymer-2 (40 g) | 0.05 g | 630 |
| Composition B-13 | Polyolefin-4 (40 g) | Organometallic functional group-containing olefinic polymer-1 (0.004 g) | 0.05 g | 0.021 |
| Composition B-14 | Polyolefin-5 (40 g) | Organometallic functional group-containing olefinic polymer-1 (0.4 g) | 0.05 g | 2.1 |
| Composition B-15 | Polyolefin -6 (40 g) | Organometallic functional group-containing olefinic polymer-1 (0.4 g) | 0.05 g | 2.1 |
| Composition B-16 | Polyolefin-7 (40 g) | Organometallic functional group-containing olefinic polymer-1 (0.4 g) | 0.05 g | 2.1 |

| | | | | |
|---|---|---|---|---|
| *1: 2,6-Di-t-butyl-4-methylphenol | | | | |

### (Production of Composition C)

40 g of polyolefin-4 and 0.05 g of 2,6-di-t-butyl-4-methylphenol were melt-kneaded by using a laboplast mill (200°C, 60 rpm, 5 min) to obtain the Composition C-1.

### [Example 1]

A film obtained by hot press (150°C, 12 kg/cm², 30 min) of the Composition A-1 in a 10 cm × 10 cm × 1 mm frame (film A-1) and a film obtained by hot press (200°C, 12 kg/cm², 5 min) of the Composition B-1 in a 10 cm × 10 cm × 1 mm frame (film B-1) were overlaid with each other and subjected to heat treatment at 135°C for 30 min under the pressure of 12 kg/cm² to obtain the laminate-1 (layer A/layer B).

### (Evaluation of adhesiveness)

The laminate-1 was cut to a rectangle with a size of 1 cm × 10 cm and dried/wetted overnight at 23°C, 50% RH. The rectangle was subjected to peeling so that the layer A and the layer B are separated from each other 2 cm from the end of the long side of the rectangle, 180° peeling test was performed five times with a rate of 100 mm/min by using an autograph (trade name: AG-IS, manufactured by Shimadzu Corporation), and an average value of the five measurements of interlayer adhesion was obtained. The measurement results are shown in the Table 5.

### [Examples 2 to 12]

The laminate was produced in the same manner as the Example 1 except that each of the Composition B-2 to 12 was used instead of the Composition B-1 and subjected to the same evaluation as the Example 1. The measurement results are shown in the Table 5.

### [Examples 13 and 14]

The laminate was produced in the same manner as the Example 1 except that each of the Composition A-2 or 3 was used instead of the Composition A-1 and subjected to the same evaluation as the Example 1. The measurement results are shown in the Table 5.

### [Example 15]

A film obtained by hot press (150°C, 12 kg/cm², 30 min) of the Composition A-1 in a 10 cm × 10 cm × 1 mm frame (film A-1) and coating of a toluene solution (1 wt%) of the Composition B-1 on one surface of the film A-1 by using an applicator (thickness of the coated solution: 10 µm) and a film obtained by hot press (200°C, 12 kg/cm², 5 min) of the Composition C-1 in a 10 cm × 10 cm × 1 mm frame (film C-1) were overlaid with each other so that the surface coated with the Composition B-1 is in contact with the film C-1, and then subjected to heat treatment at 135°C for 30 min under the pressure of 12 kg/cm² to obtain the laminate-15 (layer A/layer B/layer C).

### (Evaluation of adhesiveness)

The laminate-15 was cut to a rectangle with a size of 1 cm × 10 cm and dried/wetted overnight at 23°C, 50% RH. The rectangle was subjected to peeling so that the layer A and the layer C are separated from each other 2 cm from the end of the long side of the rectangle, 180° peeling test was performed five times with a rate of 100 mm/min by using an autograph (trade name: AG-IS, manufactured by Shimadzu Corporation), and an average value of the five measurements of interlayer adhesion was obtained. The measurement results are shown in the Table 5.

### [Example 16]

Two sheets of the film obtained by hot press (150°C, 12 kg/cm², 30 min) of the Composition A-1 in a 10 cm × 10 cm × 0.4 mm frame (film A-1') and a film obtained by hot press (200°C, 12 kg/cm², 5 min) of the Composition B-1 in a 10 cm × 10 cm × 0.2 mm frame (film B-1') were overlaid in the order of A-1'/B-1'/A-1' and subjected to heat treatment at 135°C for 30 min under the pressure of 12 kg/cm² to obtain the laminate-16 (layer A/layer B/layer A).

The laminate-16 and two sheets of a float plate glass (10 cm × 10 cm × 2 mm) were overlaid in the order of float plate glass/laminate-16/float plate glass and deaerated at 50°C using a nip roll. After performing the adhesion in an autoclave (140°C, 12 bar, 2 hours), the laminated glass-16 was obtained. By using a haze meter manufactured by Suga Test Instruments Co., Ltd., haze of the laminated glass was evaluated. The evaluation results are shown in the Table 5.

### [Example 17]

Two sheets of the film obtained by hot press (150°C, 12 kg/cm², 30 min) of the Composition A-1 in a 10 cm × 10 cm × 0.4 mm frame (film A-1') and coating of a toluene solution (1 wt%) of the Composition B-1 on one surface of the film A-1' by using an applicator (thickness of the coated solution: 10 µm) and a sheet of a film obtained by hot press (200°C, 12 kg/cm², 5 min) of the Composition C-1 in a 10 cm × 10 cm × 0.2 mm frame (film C-1) were overlaid with one another in the order of A-1'/C-1/A-1' and also the surface coated with the Composition B-1 is in contact with the film C-1, and then subjected to heat treatment at 135°C for 30 min under the pressure of 12 kg/ cm² to obtain the laminate-17 (layer A/layer B/layer C/layer B/layer A).

A laminated glass was obtained in the same manner as the Example 16 except that the laminate-17 was used instead of the laminate-16 and subjected to haze measurement. The results are shown in the Table 5.

### [Examples 18 to 20]

The laminate was produced in the same manner as the Example 1 except that each of the Composition B-14 to 16 was used instead of the Composition B-1 and subjected to the same evaluation as the Example 1. The measurement results are shown in the Table 5.

### [Comparative example 1]

The laminate was produced in the same manner as the Example 1 except that the Composition C-1 was used instead of the Composition B-1 and subjected to the same evaluation as the Example 1. The measurement results are shown in the Table 5.

### [Comparative example 2]

The laminate was produced in the same manner as the Example 1 except that the Composition B-13 was used instead of the Composition B-1 and subjected to the same evaluation as the Example 1. The measurement results are shown in the Table 5.

**[Table 5]**

| | Composition A | Composition B | Composition C | Layer constitution | Interlayer adhesion (N/cm) | Haze of laminated glass |
|---|---|---|---|---|---|---|
| Example 1 | A-1 | B-1 | - | Layer A/Layer B | 12.1 | - |
| Example 2 | A-1 | B-2 | - | Layer A/Layer B | 16.9 | - |
| Example 3 | A-1 | B-3 | - | Layer A/Layer B | 20.1 | - |
| Example 4 | A-1 | B-4 | - | Layer A/Layer B | 4.1 | - |
| Example 5 | A-1 | B-5 | - | Layer A/Layer B | 15.0 | - |
| Example 6 | A-1 | B-6 | - | Layer A/Layer B | 19.4 | - |
| Example 7 | A-1 | B-7 | - | Layer A/Layer B | 23.2 | - |
| Example 8 | A-1 | B-8 | - | Layer A/Layer B | 13.4 | - |
| Example 9 | A-1 | B-9 | - | Layer A/Layer B | 8.9 | - |
| Example 10 | A-1 | B-10 | - | Layer A/Layer B | 7.6 | - |
| Example 11 | A-1 | B-11 | - | Layer A/Layer B | 6.2 | - |
| Example 12 | A-1 | B-12 | - | Layer A/Layer B | 22.7 | - |
| Example 13 | A-2 | B-1 | - | Layer A/Layer B | 14.5 | - |
| Example 14 | A-3 | B-1 | - | Layer A/Layer B | 11.6 | - |
| Example 15 | A-1 | B-1 | C-1 | Layer A/Layer B /Layer C | 11.2 | - |
| Example 16 | A-1 | B-1 | - | Layer A/Layer B/Layer A | - | 0.9 |
| Example 17 | A-1 | B-1 | C-1 | Layer A/Layer B/Layer C/Layer B/Layer A | - | 1.0 |
| Example 18 | A-1 | B-14 | - | Layer A/Layer B | 10.3 | - |
| Example 19 | A-1 | B-15 | - | Layer A/Layer B | 8.5 | - |
| Example 20 | A-1 | B-16 | - | Layer A/Layer B | 11.1 | - |
| Comparative example1 | A-1 | - | C-1 | Layer A/Layer C | 0.5 | - |
| Comparative example2 | A-1 | B-13 | - | Layer A/Layer B | 0.9 | - |

### Synthetic example 9

### (Synthesis of carbon-carbon double bond-containing block copolymer)

To a 200 L pressure resistant vessel flushed with dry nitrogen, 60 kg of cyclohexane and 15.6 g of sec-butyl lithium as a polymerization initiator were added followed by addition of 1.45 kg of styrene. After polymerization at 50 to 52°C, 0.48 kg of THF was added and 13.8 kg of isoprene and 1.45 kg of styrene were added in order for polymerization. As a result, a styrene-isoprene-styrene type block copolymer was obtained. The block copolymer obtained was hydrogenated by using Pd/C in cyclohexane with hydrogen pressure of 2 MPa and reaction temperature of 100°C to obtain the carbon-carbon double bond-containing block copolymer (polyolefin-8). The polyolefin-8 obtained has a weight average molecular weight of 87,000, styrene content of 16% by mass, and hydrogenation ratio of 98 mol% (content of the carbon-carbon double bond: 250 µeq/g). The results are shown in the Table 6.

### Synthetic example 10

### (Synthesis of carbon-carbon double bond-containing block copolymer)

The polyolefin-9 was obtained in the same manner as the Synthetic example 9 except that the reaction time for hydrogenation is extended and the hydrogenation ratio is 99 % (content of the carbon-carbon double bond: 125 µeq/g). The results are shown in the Table 6.

**[Table 6]**

| | Structure | Weight average molecular weight | Amount of double bond (µeq/g) |
|---|---|---|---|
| Polyolefin-8 | Styrene-butadiene block copolymer (styrene 16% by mass) | 87,000 | 250 |
| Polyolefin-9 | Styrene-butadiene block copolymer (styrene 16% by mass) | 87,000 | 125 |

### Synthetic example 11

### (Synthesis of reactive functional group-containing olefinic polymer-1)

To a separable flask, 200 g of the polyolefin-8 obtained from the Synthetic example 9, 20 g of maleic anhydride, 1000 g of xylene, and 0.5 g of dicumyl peroxide were added, flushed with nitrogen, and reacted for 2 hours at 130°C. Thereafter, by sufficient washing with acetone, unreacted maleic anhydride and byproducts were removed. After drying, the reactive functional group-containing olefinic polymer-1 wherein the amount of carboxylic anhydride group is 200 µeq/g was obtained. The results are shown in the Table 7.

### Synthetic example 12

### (Synthesis of reactive functional group-containing olefinic polymer-2)

The reactive functional group-containing olefinic polymer-2 wherein the amount of carboxylic anhydride group is 50 µeq/g was obtained in the same manner as the Synthetic example 11 except that the polymer-3 is used instead of the polyolefin-8. The results are shown in the Table 7.

### Synthetic example 13

### (Synthesis of reactive functional group-containing olefinic polymer-3)

To a separable flask, 20 g of the polyolefin-8 obtained from the Synthetic example 9 and 100 g of 1% methylene chloride solution of m-chloro perbenzoic acid were added and reacted for 1 day at room temperature. Thereafter, by sufficient washing with acetone and drying, the reactive functional group-containing olefinic polymer-3 wherein the amount of epoxy group is 80 µeq/g was obtained. The results are shown in the Table 7.

### Synthetic example 14

### (Synthesis of reactive functional group-containing olefinic polymer-4)

The reactive functional group-containing olefinic polymer-4 wherein the amount of epoxy group is 37 µeq/g was obtained in the same manner as the Synthetic example 13 except that the polymer-3 is used instead of the polyolefin-8. The results are shown in the Table 7.

**[Table 7]**

| | Type of reactive functional group | Amount of reactive functional group (µeq/g) | Weight average molecular weight |
|---|---|---|---|
| Reactive functional group-containing olefinic polymer-1 | Carboxylic anhydride group | 200 | 87,000 |
| Reactive functional group-containing olefinic polymer-2 | Carboxylic anhydride group | 50 | 80,000 |
| Reactive functional group-containing olefinic polymer-3 | Epoxy group | 80 | 87,000 |
| Reactive functional group-containing olefinic polymer-4 | Epoxy group | 37 | 80,000 |

### (Production of Composition B-17)

40 g of polyolefin-9, 0.8 g of reactive functional group-containing olefinic polymer-1, and 0.05 g of 2,6-di-t-butyl-4-methylphenol were melt-kneaded by using a laboplast mill (200°C, 60 rpm, 5 min) to obtain the Composition B-17. The results are shown in the Table 8.

### (Production of Composition B-18 and B-19)

The Composition B-18 and B-19 were obtained in the same manner as the Composition B-17 except that the amount of the reactive functional group-containing olefinic polymer-1 is changed to 2 g and 4 g, respectively. The results are shown in the Table 8.

### (Production of Composition B-20)

The Composition B-20 was obtained in the same manner as the Composition B-18 except that the reactive functional group-containing olefinic polymer-2 was used instead of the reactive functional group-containing olefinic polymer-1. The results are shown in the Table 8.

### (Production of Composition B-21)

The Composition B-21 was obtained in the same manner as the Composition B-20 except that polypropylene (manufactured by Japan Polypropylene Corporation, Novatec PP) was used instead of the polyolefin-9. The results are shown in the Table 8.

### (Production of Composition B-22)

The Composition B-22 was obtained in the same manner as the Composition B-17 except that the reactive functional group-containing olefinic polymer-3 was used instead of the reactive functional group-containing olefinic polymer-1. The results are shown in the Table 8.

### (Production of Composition B-23 and B-24)

The Composition B-23 and B-24 were obtained in the same manner as the Composition B-22 except that the amount of the reactive functional group-containing olefinic polymer-3 is changed to 2 g and 4 g, respectively. The results are shown in the Table 8.

### (Production of Composition B-25)

The Composition B-25 was obtained in the same manner as the Composition B-18 except that the reactive functional group-containing olefinic polymer-4 was used instead of the reactive functional group-containing olefinic polymer-1. The results are shown in the Table 8.

### (Production of Composition B-26)

The Composition B-26 was obtained in the same manner as the Composition B-23 except that polypropylene (manufactured by Japan Polypropylene Corporation, Novatec PP) was used instead of the polyolefin-9. The results are shown in the Table 8.

### (Production of Composition B-27)

40 g of reactive functional group-containing olefinic polymer-1 and 0.05 g of 2,6-di-t-butyl-4-methylphenol were melt-kneaded by using a laboplast mill (200°C, 60 rpm, 5 min) to obtain the Composition B-27. The results are shown in the Table 8.

### (Production of Composition B-28)

The Composition B-28 was obtained in the same manner as the Composition B-17 except that the amount of the reactive functional group-containing olefinic polymer-1 is changed to 0.04 g. The results are shown in the Table 8.

**[Table 8]**

| | Polyolefin | Reactive functional group-containing olefinic polymer | AO*¹ | Amount of reactive functional group (µeq/g) |
|---|---|---|---|---|
| Composition B-17 | Polyolefin-9 (40 g) | Reactive functional group-containing olefinic polymer-1 (0.8 g) | 0.05 g | 3.9 |
| Composition B-18 | Polyolefin-9 (40 g) | Reactive functional group-containing olefinic polymer-1 (2 g) | 0.05 g | 9.5 |
| Composition B-19 | Polyolefin-9 (40 g) | Reactive functional group-containing olefinic polymer-1 (4 g) | 0.05 g | 18.2 |
| Composition B-20 | Polyolefin-9 (40 g) | Reactive functional group-containing olefinic polymer-2 (2 g) | 0.05 g | 2.4 |
| Composition B-21 | Novatec PP (40 g) | Reactive functional group-containing olefinic polymer-2 (2 g) | 0.05 g | 2.4 |
| Composition B-22 | Polyolefin-9 (40 g) | Reactive functional group-containing olefinic polymer-3 (0.8 g) | 0.05 g | 1.6 |
| Composition B-23 | Polyolefin-9 (40 g) | Reactive functional group-containing olefinic polymer-3 (2 g) | 0.05 g | 3.8 |
| Composition B-24 | Polyolefin-9 (40 g) | Reactive functional group-containing olefinic polymer-3 (4 g) | 0.05 g | 7.3 |
| Composition B-25 | Polyolefin-9 (40 g) | Reactive functional group-containing olefinic polymer-4 (2 g) | 0.05 g | 1.8 |
| Composition B-26 | Novatec PP (40 g) | Reactive functional group-containing olefinic polymer-3 (2 g) | 0.05 g | 3.8 |
| Composition B-27 | - | Reactive functional group-containing olefinic polymer-1 (40 g) | 0.05 g | 200.0 |
| Composition B-28 | Polyolefin-9 (40 g) | Reactive functional group-containing olefinic polymer-1 (0.04 g) | 0.05 g | 0.2 |

| | | | | |
|---|---|---|---|---|
| *1: 2,6-Di-t-butyl-4-methylphenol | | | | |

### (Production of Composition C-2)

40 g of polyolefin-9 and 0.05 g of 2,6-di-t-butyl-4-methylphenol were melt-kneaded by using a laboplast mill (200°C, 60 rpm, 5 min) to obtain the Composition C-2.

### [Example 21]

A film obtained by hot press (150°C, 12 kg/cm², 30 min) of a film of the Composition A-1 in a 10 cm × 10 cm × 1 mm frame (film A-1) and a film obtained by hot press (200°C, 12 kg/cm², 5 min) of the Composition B-17 in a 10 cm × 10 cm × 1 mm frame (film B-1) were overlaid with each other and subjected to heat treatment at 135°C for 30 min under the pressure of 12 kg/cm² to obtain the laminate-21 (layer A/layer B).

### (Evaluation of adhesiveness)

The laminate-21 was cut to a rectangle with a size of 1 cm × 10 cm and dried/wetted overnight at 23°C, 50% RH. The rectangle was subjected to peeling so that the layer A and the layer B are separated from each other 2 cm from the end of the long side of the rectangle, 180° peeling test was performed five times with a rate of 100 mm/min by using an autograph (trade name: AG-IS, manufactured by Shimadzu Corporation), and an average value of the five measurements of interlayer adhesion was obtained. The measurement results are shown in the Table 9.

### [Examples 22 to 31]

The laminate was produced in the same manner as the Example 21 except that each of the Composition B-18 to 27 was used instead of the Composition B-17 and subjected to the same evaluation as the Example 21. The measurement results are shown in the Table 9.

### [Examples 32 and 33]

The laminate was produced in the same manner as the Example 21 except that each of the Composition A-2 or A-3 was used instead of the Composition A-1 and subjected to the same evaluation as the Example 21. The measurement results are shown in the Table 9.

### [Example 34]

A film obtained by hot press (150°C, 12 kg/cm², 30 min) of the Composition A-1 in a 10 cm × 10 cm × 1 mm frame (film A-1) and coating of a toluene solution (1 wt%) of the Composition B-17 on one surface of the film A-1 by using an applicator (thickness of the coated solution: 10 µm) and a film obtained by hot press (200°C, 12 kg/cm², 5 min) of the Composition C-2 in a 10 cm × 10 cm × 1 mm frame (film C-2) were overlaid with each other so that the surface coated with the Composition B-17 is in contact with the film C-2, and then subjected to heat treatment at 135°C for 30 min under the pressure of 12 kg/cm² to obtain the laminate-34 (layer A/layer B/layer C).

### (Evaluation of adhesiveness)

The laminate-34 was cut to a rectangle with a size of 1 cm × 10 cm and dried/wetted overnight at 23°C, 50% RH. The rectangle was subjected to peeling so that the layer A and the layer C are separated from each other 2 cm from the end of the long side of the rectangle, 180° peeling test was performed five times with a rate of 100 mm/min by using an autograph (trade name: AG-IS, manufactured by Shimadzu Corporation), and an average value of the five measurements of interlayer adhesion was obtained. The measurement results are shown in the Table 9.

### [Example 35]

Two sheets of the film obtained by hot press (150°C, 12 kg/cm², 30 min) of the Composition A-1 in a 10 cm × 10 cm × 0.4 mm frame (film A-1') and a film obtained by hot press (200°C, 12 kg/cm², 5 min) of the Composition B-17 in a 10 cm × 10 cm × 0.2 mm frame (film B-17') were overlaid in the order of (film A-1')/ (film B-17')/ (film A-1') and subjected to heat treatment at 135°C for 30 min under the pressure of 12 kg/cm² to obtain the laminate-35 (layer A/layer B/layer A).

The laminate-35 and two sheets of a float plate glass (10 cm × 10 cm × 2 mm) were overlaid in the order of (float plate glass) / (laminate-35) / (float plate glass) and deaerated at 50°C using a nip roll. After performing the adhesion in an autoclave (140°C, 12 bar, 2 hours), the laminated glass-15 was obtained. By using a haze meter manufactured by Suga Test Instruments Co., Ltd., haze of the laminated glass was evaluated. The evaluation results are shown in the Table 9.

### [Example 36]

Two sheets of a film obtained by hot press (150°C, 12 kg/cm², 30 min) of the Composition A-1 in a 10 cm × 10 cm × 0.4 mm frame (film A-1') and coating of a toluene solution (1 wt%) of the Composition B-17 on one surface of the film A-1' by using an applicator (thickness of the coated solution: 10 µm) and a sheet of a film obtained by hot press (200°C, 12 kg/cm², 5 min) of the Composition C-2 in a 10 cm × 10 cm × 0.2 mm frame (film B-17') were overlaid with one another in the order of (film A-1')/ (film B-17')/ (film A-1') and also the surface coated with the Composition B-17 is in contact with the film B-17', and then subjected to heat treatment at 135°C for 30 min under the pressure of 12 kg/cm² to obtain the laminate-36 ((layer A/layer B/layer C/layer B/layer A).

A laminated glass was obtained in the same manner as the Example 35 except that the laminate-36 was used instead of the laminate-35 and subjected to haze measurement. The results are shown in the Table 9.

### [Comparative example 3]

The laminate was produced in the same manner as the Example 21 except that each of the Composition C-2 was used instead of the Composition B-17 and subjected to the same evaluation as the Example 21. The measurement results are shown in the Table 9.

### [Comparative example 4]

The laminate was produced in the same manner as the Example 21 except that each of the Composition B-28 was used instead of the Composition B-17 and subjected to the same evaluation as the Example 21. The measurement results are shown in the Table 9.

**[Table 9]**

| | Composition A | Composition B | Composition C | Layer constitution | Interlayer adhesion (N/cm) | Haze of laminated glass |
|---|---|---|---|---|---|---|
| Example 21 | A-1 | B-17 | - | Layer A/Layer B | 4.7 | - |
| Example 22 | A-1 | B-18 | - | Layer A/Layer B | 5.7 | - |
| Example 23 | A-1 | B-19 | - | Layer A/Layer B | 6.4 | - |
| Example 24 | A-1 | B-20 | - | Layer A/Layer B | 3.9 | - |
| Example 25 | A-1 | B-21 | - | Layer A/Layer B | 3.8 | - |
| Example 26 | A-1 | B-22 | - | Layer A/Layer B | 4.0 | - |
| Example 27 | A-1 | B-23 | - | Layer A/Layer B | 4.9 | - |
| Example 28 | A-1 | B-24 | - | Layer A/Layer B | 6.0 | - |
| Example 29 | A-1 | B-25 | - | Layer A/Layer B | 3.9 | - |
| Example 30 | A-1 | B-26 | - | Layer A/Layer B | 5.0 | - |
| Example 31 | A-1 | B-27 | - | Layer A/Layer B | 7.1 | - |
| Example 32 | A-2 | B-17 | - | Layer A/Layer B | 5.0 | - |
| Example 33 | A-3 | B-17 | - | Layer A/Layer B | 4.8 | - |
| Example 34 | A-1 | B-17 | C-2 | Layer A/Layer B/Layer C | 4.9 | - |
| Example 35 | A-1 | B-17 | - | Layer A/Layer B/Layer A | - | 0.9 |
| Example 36 | A-1 | B-17 | C-2 | Layer A/Layer B/Layer C/Layer B/Layer A | - | 0.9 |
| Comparative example 3 | A-1 | - | C-2 | Layer A/Layer C | 0.5 | - |
| Comparative example 4 | A-1 | B-28 | - | Layer A/Layer B | 0.7 | - |

### INDUSTRIAL APPLICABILITY

According to the laminate of the invention, a silicon or a boron in the organometallic functional group-containing olefinic polymer which is contained as an essential component in the composition B may react with the hydroxy group contained in the polyvinyl acetal to form a covalent bond, or may form a strong hydrogen bond with the hydroxy group contained in the polyvinyl acetal, and also since the organometallic functional group-containing olefinic polymer mostly consists of a polymer of a hydrocarbon monomer, it can be adhered or used together with polyolefin which has relatively similar molecular polarity. Further, according to the laminate of the invention, at least one group selected from a carboxyl group, a derivative group of a carboxyl group, and an epoxy group in the reactive functional group-containing olefinic polymer which is contained as an essential component in the composition B may react with the hydroxy group contained in the polyvinyl acetal to form a covalent bond, and also since the reactive functional group-containing olefinic polymer mostly consists of a polymer of a hydrocarbon monomer, it can be adhered or used together with polyolefin which has relatively similar molecular polarity.

Accordingly, a laminate which is obtained by laminating a layer A that comprises a composition A and a layer B that comprises a composition B or a laminate which is obtained by laminating a layer A and a layer C that comprises a composition C via a layer B that comprises a composition B has excellent interlayer adhesion between the layer A and the layer B or the layer A and layer C, and the laminates are particularly preferably used for an intermediate film of a laminated glass.

### EXPLANATIONS OF REFERENCE NUMERALS

- 1: GLASS OR THE LIKE
- 2: FILLER
- 3: SOLAR CELL (CRYSTAL SYSTEM)
- 4: SOLAR CELL (THIN FILM TYPE)

## Claims

1. A laminate obtained by laminating a layer A that comprises a composition A containing a polyvinyl acetal and a layer B that comprises a composition B containing a polyolefin and an adhesive functional group-containing olefinic polymer or containing an adhesive functional group-containing olefinic polymer,
wherein a mass ratio of (the polyolefin) / (the adhesive functional group-containing olefinic polymer) is 0/100 to 99.95/0.05, and
wherein the adhesive functional group-containing olefinic polymer is an adhesive functional group-containing olefinic polymer having an organometallic functional group that comprises boron and/or silicon or is an adhesive functional group-containing olefinic polymer having at least one reactive functional group that is selected from a carboxyl group, a derivative group of a carboxyl group, and an epoxy group.

2. The laminate according to Claim 1, wherein the organometallic functional group is at least one group selected from a group consisting of a boronic acid group, a derivative group of boronic acid group, a borinic acid group, a derivative group of borinic acid group, or an alkoxysilyl group and a derivative group of an alkoxysilyl group.

3. The laminate according to Claim 2, wherein the amount of the organometallic functional group in the layer B is 0.1 to 1500 µeq/g in terms of boron atom or silicon atom.

4. The laminate according to Claim 1, wherein the reactive functional group is at least one group selected from a carboxyl group and a derivative group of a carboxyl group or is an epoxy group.

5. The laminate according to Claim 4, wherein the amount of the reactive functional group in the layer B is 1 to 1500 µeq/g.

6. The laminate according to any one of Claims 1 to 5, wherein a layer C that comprises a composition C containing a polyolefin and the layer A are laminated via the layer B.

7. The laminate according to any one of Claims 1 to 6, wherein the polyolefin is a polymer containing at least one monomer unit selected from a group consisting of an aliphatic unsaturated hydrocarbon having 2 to 12 carbon atoms and an aromatic unsaturated hydrocarbon having 8 to 12 carbon atoms, or a hydrogenated molecule thereof.

8. The laminate according to Claim 7, wherein the polyolefin is a block copolymer comprising a block (X) consisting of a polymer of an aromatic unsaturated hydrocarbon compound having 8 to 12 carbon atoms and a block (Y) consisting of a polymer of an aliphatic conjugated polymer compound having 2 to 12 carbon atoms, or a hydrogenated molecule thereof.

9. The laminate according to any one of Claims 1 to 8, wherein the adhesive functional group-containing olefinic polymer is a polymer consisting of at least one monomer unit selected from a group consisting of an aliphatic unsaturated hydrocarbon unit having 2 to 12 carbon atoms and an aromatic unsaturated hydrocarbon unit having 8 to 12 carbon atoms, or a hydrogenated molecule thereof, or the adhesive functional group is contained in the terminal or the side chain of the molecular chain.

10. The laminate according to Claim 9, wherein the adhesive functional group-containing olefinic polymer is a block copolymer comprising a block (X') consisting of a polymer of an aromatic unsaturated hydrocarbon unit having 8 to 12 carbon atoms and a block (Y') consisting of a polymer of an aliphatic conjugated polyene unit having 2 to 12 carbon atoms, or a hydrogenated molecule thereof, and the adhesive functional group is contained in the terminal or the side chain of the molecular chain.

11. The laminate according to Claim 8 or 10, wherein the aromatic unsaturated hydrocarbon compound having 8 to 12 carbon atoms is styrene and the aliphatic conjugated polymer compound having 2 to 12 carbon atoms is butadiene, isoprene, or a mixture of butadiene and isoprene.

12. The laminate according to any one of Claims 1 to 11, wherein the polyvinyl acetal is obtained by acetalization of polyvinyl alcohol having viscosity average polymerization degree of 150 to 3000.

13. The laminate according to any one of Claims 1 to 12, wherein the polyvinyl acetal is polyvinyl butyral.

14. The laminate according to any one of Claims 1 to 13, wherein the average acetalization degree of polyvinyl acetal is 40 to 85 mol% and average amount of vinyl acetate group is 0.01 to 30 mol%.

15. The laminate according to any one of Claims 1 to 14, wherein the layer A comprises 1 to 100 parts by mass of plasticizer compared to 100 parts by mass of polyvinyl acetal.

16. A laminated glass containing the laminate described in any one of Claims 1 to 15.

17. A solar cell module containing the laminate described in any one of Claims 1 to 15.

## Patentansprüche

1. Laminat, erhalten durch Laminieren einer Schicht A, die eine Zusammensetzung A mit einem Polyvinylacetal und eine Schicht mit einer Zusammensetzung B, die ein Pololefin und ein Adhäsiv-funktionelles Gruppen-haltiges olefinisches Polymer oder ein Adhäsiv-funktionelles Gruppen-haltiges olefinisches Polymer enthält,
worin ein Massenverhältnis des (Polyolefins)/(Adhäsivfunktionellen Gruppen-haltigen olefinischen Polymers 0/100 bis 99,95/0,05 ist und
worin das Adhäsiv-funktionelle Gruppen-haltige olefinische Polymer ein Adhäsiv-funktionelles Gruppen-haltiges olefinisches Polymer mit einer organometallischen funktionellen Gruppe, die Bor und/oder Silicium enthält, oder ein Adhäsiv-funktionelles Gruppen-haltiges olefinisches Polymer mit zumindest einer reaktiven funktionellen Gruppe ist, die ausgewählt ist aus einer Carboxylgruppe, einer Derivatgruppe einer Carboxylgruppe und eine Epoxygruppe.

2. Laminat gemäß Anspruch 1, worin die organometallische funktionelle Gruppe zumindest eine Gruppe ist, ausgewählt aus einer Gruppe, bestehend aus einer Boronsäuregruppe, einer Derivatgruppe einer Boronsäuregruppe, einer Borinsäuregruppe, einer Derivatgruppe einer Borinsäuregruppe oder einer Alkoxysilylgruppe und einer Derivatgruppe einer Alkoxysilylgruppe.

3. Laminat gemäß Anspruch 2, worin die Menge der organometallischen funktionellen Gruppe in der Schicht B 0,1 bis 1.000 µEq/g als Boratom oder Siliciumatom ist.

4. Laminat gemäß Anspruch 1, worin die reaktive funktionelle Gruppe zumindest eine Gruppe, ausgewählt aus einer Carboxylgruppe und einer Derivatgruppe einer Carboxylgruppe oder eine Epoxygruppe ist.

5. Laminat gemäß Anspruch 4, worin die Menge der reaktiven funktionellen Gruppe in der Schicht B 1 bis 1.500 µEq/g ist.

6. Laminat gemäß einem der Ansprüche 1 bis 5, worin eine Schicht C, die eine Zusammensetzung C mit einem Polyolefin enthält, und die Schicht A über die Schicht B laminiert sind.

7. Laminat gemäß einem der Ansprüche 1 bis 6, worin das Polyolefin ein Polymer mit zumindest einer Monomereinheit ist, ausgewählt aus einer Gruppe, bestehend aus einem aliphatischen ungesättigten Kohlenwasserstoff mit 2 bis 12 Kohlenstoffatomen und einem aromatischen ungesättigten Kohlenwasserstoff mit 8 bis 12 Kohlenstoffatomen oder ein hydriertes Molekül davon.

8. Laminat gemäß Anspruch 7, worin das Polyolefin ein Blockcopolymer mit einem Block (X), der aus einem Polymer einer aromatischen ungesättigten Kohlenwasserstoffverbindung mit 8 bis 12 Kohlenstoffatomen, und einem Block (Y), bestehend aus einem Polymer aus einer aliphatischen konjugierten Polymerverbindung mit 2 bis 12 Kohlenstoffatomen, oder ein hydriertes Molekül davon ist.

9. Laminat gemäß einem der Ansprüche 1 bis 8, worin das Adhäsiv-funktionelle Gruppen-haltige olefinische Polymer ein Polymer, bestehend aus zumindest einer Monomereinheit, ausgewählt aus einer Gruppe, bestehend aus einer aliphatischen ungesättigten Kohlenwasserstoffeinheit mit 2 bis 12 Kohlenstoffatomen und einer aromatischen ungesättigten Kohlenwasserstoffeinheit mit 8 bis 12 Kohlenstoffatomen oder ein hydriertes Molekül davon ist, oder worin die adhäsive funktionelle Gruppe in dem Ende oder der Seitenkette der Molekülkette enthalten ist.

10. Laminat gemäß Anspruch 9, worin das Adhäsiv-funktionelle Gruppen-haltige olefinische Polymer ein Blockcopolymer ist, enthaltend einen Block (X'), bestehend aus einem Polymer aus einer aromatischen ungesättigten Kohlenwasserstoffeinheit mit 8 bis 12 Kohlenstoffatomen, und einen Block (Y'), bestehend aus einem Polymer aus einer aliphatischen konjugierten Polyeneinheit mit 2 bis 12 Kohlenstoffatomen, oder ein hydriertes Molekül davon und die adhäsive funktionelle Gruppe in dem Ende oder der Seitenkette der Molekülkette enthalten ist.

11. Laminat gemäß Anspruch 8 oder 10, worin die aromatische ungesättigte Kohlenwasserstoffverbindung mit 8 bis 12 Kohlenstoffatomen Styrol und die aliphatische konjugierte Polymerverbindung mit 2 bis 12 Kohlenstoffatomen Butadien, Isopren oder eine Mischung aus Butadien und Isopren ist.

12. Laminat gemäß einem der Ansprüche 1 bis 11, worin das Polyvinylacetal erhalten ist durch Acetalisierung von Polyvinylalkohol mit einem Polymerisationsgrad im Viskositätsmittel von 150 bis 3.000.

13. Laminat gemäß einem der Ansprüche 1 bis 12, worin das Polyvinylacetal Polyvinylbutyral ist.

14. Laminat gemäß einem der Ansprüche 1 bis 13, worin der durchschnittliche Acetalisierungsgrad von Polyvinylacetal 40 bis 85 mol-% und die Durchschnittsmenge der Vinylacetatgruppe 0,01 bis 30 mol-% ist.

15. Laminat gemäß einem der Ansprüche 1 bis 14, worin die Schicht A 1 bis 100 Masseteile eines Plastifizierers im Vergleich zu 100 Masseteilen Polyvinylacetal enthält.

16. Laminiertes Glas, enthaltend das Laminat gemäß einem der Ansprüche 1 bis 15.

17. Solarzellenmodul, enthaltend das Laminat gemäß einem der Ansprüche 1 bis 15.

## Revendications

1. Stratifié obtenu en stratifiant une couche A qui comprend une composition A contenant un poly(acétal de vinyle) et une couche B qui comprend une composition B contenant une polyoléfine et un polymère oléfinique contenant un groupe fonctionnel adhésif ou contenant un polymère oléfinique contenant un groupe fonctionnel adhésif,
dans lequel un rapport en masse de (la polyoléfine)/(le polymère oléfinique contenant un groupe fonctionnel adhésif) est de 0/100 à 99,95/0,05, et
dans lequel le polymère oléfinique contenant un groupe fonctionnel adhésif est un polymère oléfinique contenant un groupe fonctionnel adhésif présentant un groupe fonctionnel organométallique qui comprend du bore et/ou du silicium ou est un polymère oléfinique contenant un groupe fonctionnel adhésif présentant au moins un groupe fonctionnel réactif qui est choisi parmi un groupe carboxyle, un groupe dérivé d'un groupe carboxyle et un groupe époxy.

2. Stratifié selon la revendication 1, dans lequel le groupe fonctionnel organométallique est au moins un groupe choisi dans un groupe consistant en un groupe acide boronique, un groupe dérivé de groupe acide boronique, un groupe acide borinique, un groupe dérivé de groupe acide borinique ou un groupe alcoxysilyle et un groupe dérivé d'un groupe alcoxysilyle.

3. Stratifié selon la revendication 2, dans lequel la quantité du groupe fonctionnel organométallique dans la couche B est de 0,1 à 1500 µeq/g en termes d'atome de bore ou d'atome de silicium.

4. Stratifié selon la revendication 1, dans lequel le groupe fonctionnel réactif est au moins un groupe choisi parmi un groupe carboxyle et un groupe dérivé d'un groupe carboxyle ou est un groupe époxy.

5. Stratifié selon la revendication 4, dans lequel la quantité du groupe fonctionnel réactif dans la couche B est de 1 à 1500 µeq/g.

6. Stratifié selon l'une quelconque des revendications 1 à 5, dans lequel une couche C qui comprend une composition C contenant une polyoléfine et la couche A sont stratifiées via la couche B.

7. Stratifié selon l'une quelconque des revendications 1 à 6, dans lequel la polyoléfine est un polymère contenant au moins une unité monomère choisie dans un groupe consistant en un hydrocarbure insaturé aliphatique présentant 2 à 12 atomes de carbone et un hydrocarbure insaturé aromatique présentant 8 à 12 atomes de carbone, ou une molécule hydrogénée de celui-ci.

8. Stratifié selon la revendication 7, dans lequel la polyoléfine est un copolymère bloc comprenant un bloc (X) consistant en un polymère d'un composé hydrocarbure insaturé aromatique présentant 8 à 12 atomes de carbone et un bloc (Y) consistant en un polymère d'un composé polymère conjugué aliphatique présentant 2 à 12 atomes de carbone, ou une molécule hydrogénée de celui-ci.

9. Stratifié selon l'une quelconque des revendications 1 à 8, dans lequel le polymère oléfinique contenant un groupe fonctionnel adhésif est un polymère consistant en au moins une unité monomère choisie dans un groupe consistant en une unité hydrocarbure insaturé aliphatique présentant 2 à 12 atomes de carbone et une unité hydrocarbure insaturé aromatique présentant 8 à 12 atomes de carbone, ou une molécule hydrogénée de celui-ci, ou le groupe fonctionnel adhésif est contenu dans la chaîne terminale ou latérale de la chaîne moléculaire.

10. Stratifié selon la revendication 9, dans lequel le polymère oléfinique contenant un groupe fonctionnel adhésif est un copolymère bloc comprenant un bloc (X') consistant en un polymère d'une unité hydrocarbure insaturé aromatique présentant 8 à 12 atomes de carbone et un bloc (Y') consistant en un polymère d'une unité polyène conjugué aliphatique présentant 2 à 12 atomes de carbone, ou une molécule hydrogénée de celui-ci, et le groupe fonctionnel adhésif est contenu dans la chaîne terminale ou latérale de la chaîne moléculaire.

11. Stratifié selon la revendication 8 ou 10, dans lequel le composé hydrocarbure insaturé aromatique présentant 8 à 12 atomes de carbone est du styrène et le composé polymère conjugué aliphatique présentant 2 à 12 atomes de carbone est du butadiène, de l'isoprène ou un mélange de butadiène et d'isoprène.

12. Stratifié selon l'une quelconque des revendications 1 à 11, dans lequel le poly(acétal vinylique) est obtenu par acétalisation d'alcool polyvinylique présentant un degré de polymérisation moyen viscosimétrique de 150 à 3000.

13. Stratifié selon l'une quelconque des revendications 1 à 12, dans lequel le poly(acétal de vinyle) est du poly(butyral de vinyle).

14. Stratifié selon l'une quelconque des revendications 1 à 13, dans lequel le degré d'acétalisation moyen du poly(acétal de vinyle) est de 40 à 85 % molaire et la quantité moyenne de groupe acétate de vinyle est de 0,01 à 30 % molaire.

15. Stratifié selon l'une quelconque des revendications 1 à 14, dans lequel la couche A comprend 1 à 100 parties en masse de plastifiant par rapport à 100 parties en masse de poly(acétal de vinyle).

16. Verre stratifié contenant le stratifié décrit dans l'une quelconque des revendications 1 à 15.

17. Module de cellule solaire contenant le stratifié décrit dans l'une quelconque des revendications 1 à 15.
